(19) Europäisches Patentamt / European Patent Office / Office européen des brevets

(11) **EP 3 584 824 A1**

(12) **EUROPEAN PATENT APPLICATION**
published in accordance with Art. 153(4) EPC

(43) Date of publication:
**25.12.2019 Bulletin 2019/52**

(21) Application number: **17896530.7**

(22) Date of filing: **14.02.2017**

(51) Int Cl.:
**H01L 21/336** (2006.01)   **H01L 29/12** (2006.01)
**H01L 29/78** (2006.01)

(86) International application number:
**PCT/JP2017/005333**

(87) International publication number:
**WO 2018/150467 (23.08.2018 Gazette 2018/34)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Nissan Motor Co., Ltd.**
**Yokohama-shi, Kanagawa 221-0023 (JP)**

(72) Inventors:
• **NI Wei**
  **Atsugi-shi**
  **Kanagawa 243-0123 (JP)**

• **HAYASHI Tetsuya**
  **Atsugi-shi**
  **Kanagawa 243-0123 (JP)**
• **TANAKA Ryota**
  **Atsugi-shi**
  **Kanagawa 243-0123 (JP)**
• **TAKEMOTO Keisuke**
  **Atsugi-shi**
  **Kanagawa 243-0123 (JP)**
• **HAYAMI Yasuaki**
  **Atsugi-shi**
  **Kanagawa 243-0123 (JP)**

(74) Representative: **Hoefer & Partner Patentanwälte mbB**
**Pilgersheimer Straße 20**
**81543 München (DE)**

(54) **SEMICONDUCTOR DEVICE AND SEMICONDUCTOR DEVICE PRODUCTION METHOD**

(57) There are included a first conductivity-type first drift region (4) formed on a first main surface of a substrate (1), and a first conductivity-type second drift region (41) formed on the first main surface of the substrate (1), the second drift region formed to be reached to a deeper position of the substrate (1) than a position of the first drift region (4). There are further included a second conductivity-type well region in contact with the second drift region, a first conductivity-type source region formed to extend in a direction perpendicular to a surface of the well region, and a first conductivity-type drain region separated from the well region, the drain region formed to extend in a direction perpendicular to a surface of the first drift region. Since a flow path of electrons after passing through a channel can be widened, a resistance can be reduced.

[Fig. 1F]

EP 3 584 824 A1

**Description**

TECHNICAL FIELD

The present invention relates to a semiconductor device and to a manufacturing method of such a semiconductor device.

BACKGROUND ART

There have been known conventional semiconductor devices, disclosed in Patent Literatures 1 to 3, for example. In the semiconductor device disclosed in Patent Literature 1, a drift region is formed on a substrate and a well region for forming a channel is further formed in the drift region. Furthermore, a source region and a drain region are formed in a direction perpendicular to a surface of the drift region.

A trench-shaped gate electrode is formed towards the direction perpendicular to the surface of the drift region to an inside of the drift region. According to such a structure, the semiconductor device has a lateral structure horizontal to the substrate. A principal current controlled by a voltage applied by a gate electrode flows in a direction parallel to a surface of the semiconductor and is distributed from the surface of the semiconductor in a direction perpendicular to the surface thereof.

Accordingly, a channel width can be determined in accordance with a depth of the drift region, and thereby the channel width can be increased even when the semiconductor surface has a fixed surface area. That is, the flow of the principal current is not restricted by the surface area of the semiconductor.

CITATION LIST

PATENT LITERATURE

Patent Literature 1: International Publication No. 2015/008550
Patent Literature 2: Japanese Patent Unexamined Publication No. 2006-303543
Patent Literature 3: International Publication No. 1998/059374

SUMMARY OF INVENTION

However, in the conventional example disclosed in Patent Literature 1, the channel width is defined dependent on the depth of the drift region. Thus, when increasing the channel width in order to reduce a channel resistance, it is necessary to increase the depth of the drift region. Increasing the depth of the whole drift region leads to increase of manufacturing costs.

The present invention has been made in light of the above-mentioned problem, and the object of the present invention is to provide a semiconductor device and a manufacturing method of such a semiconductor device capable of reducing the channel resistance without increasing the depth of the whole drift region.

The one aspect of the present invention includes: a first conductivity-type first drift region formed on a first main surface of a substrate; and a first conductivity-type second drift region formed on the first main surface of the substrate so as to be contacted with the first drift region, the second drift region formed to be reached to a deeper position of the substrate than a position of the first drift region. The one aspect of the present invention further includes: a second conductivity-type well region in contact with the second drift region; a first conductivity-type source region formed to extend in a direction perpendicular to a surface of the well region; and a first conductivity-type drain region formed to extend from a surface of the first drift region in a direction perpendicular to the surface of the first drift region. The one aspect of the present invention further includes: a gate insulating film; and a gate electrode formed in contact with the gate insulating film, the gate electrode further in contact with the second drift region, the well region, and the source region via the gate insulating film. The one aspect of the present invention further includes: a source electrode connected to the source region and the well region; and a drain electrode connected to the drain region.

ADVANTAGEOUS EFFECTS OF INVENTION

According to the one aspect of the present invention, the second drift region is formed to be reached to a deeper position of the substrate than a position of the first drift region. Accordingly, a flow path of electrons after passing through a channel can be widened, and thereby a resistance can be reduced.

BRIEF DESCRIPTION OF DRAWINGS

[Fig. 1A] Fig. 1A is a cross-sectional diagram showing a configuration of a semiconductor device according to a first embodiment of the present invention.
[Fig. 1B] Fig. 1B is a cross-sectional diagram showing when a first drift region is formed on the substrate, according to the first embodiment.
[Fig. 1C] Fig. 1C is a cross-sectional diagram showing when a second drift region, a well region, a source region, and a drain region are formed thereon, according to the first embodiment.
[Fig. 1D] Fig. 1D is a cross-sectional diagram showing when a gate insulating film and a gate electrode are formed thereon, according to the first embodiment.
[Fig. 1E] Fig. 1E is a cross-sectional diagram showing when an interlayer insulating film and contact holes are formed thereon, according to the first embodiment.

[Fig. 1F] Fig. 1F is an explanatory diagram showing a distribution of a current density when the semiconductor device is turned ON, according to the first embodiment.

[Fig. 1G] Fig. 1G is an explanatory diagram showing a distribution of a current density when the semiconductor device is turned ON when no second drift region is provided.

[Fig. 1H] Fig. 1H is a cross-sectional diagram showing when a mask material is deposited on the substrate, according to a modified example of the first embodiment.

[Fig. 1I] Fig. 1I is a cross-sectional diagram showing when a drift region is formed on the substrate, according to the modified example of the first embodiment.

[Fig. 2A] Fig. 2A is a cross-sectional diagram showing a configuration of a semiconductor device according to a second embodiment of the present invention.

[Fig. 2B] Fig. 2B is a cross-sectional diagram showing when a well region, a source region, and a drain region are formed on a substrate, according to the second embodiment.

[Fig. 2C] Fig. 2C is a cross-sectional diagram showing when a mask material is deposited on the substrate, according to the second embodiment.

[Fig. 2D] Fig. 2D is a cross-sectional diagram showing when a gate trench is formed in the substrate, according to the second embodiment.

[Fig. 2E] Fig. 2E is a cross-sectional diagram showing when a first drift region and a second drift region are formed on the substrate, according to the second embodiment.

[Fig. 2F] Fig. 2F is a cross-sectional diagram showing when a gate insulating film and a gate electrode are formed in the gate trench, according to the second embodiment.

[Fig. 2G] Fig. 2G is a cross-sectional diagram showing when an interlayer insulating film is formed on the substrate, according to the second embodiment.

[Fig. 2H] Fig. 2H is a cross-sectional diagram showing when a source electrode and a drain electrode are formed on the substrate, according to the second embodiment.

[Fig. 2I] Fig. 2I is a cross-sectional diagram showing a configuration of a semiconductor device according to a second modified example of the second embodiment of the present invention.

[Fig. 3A] Fig. 3A is a cross-sectional diagram showing a configuration of a semiconductor device according to a third embodiment of the present invention.

[Fig. 3B] Fig. 3B is a cross-sectional diagram showing when a well region, a source region, and a source region are formed on a substrate, according to the third embodiment.

[Fig. 3C] Fig. 3C is a cross-sectional diagram showing when a gate trench is formed in the substrate and a first drift region and a second drift region are further formed on the substrate, according to the third embodiment.

[Fig. 3D] Fig. 3D is a cross-sectional diagram showing when agate insulating film and a gate electrode are formed in the gate trench and a drain electrode is further formed on the substrate, according to the third embodiment.

[Fig. 4A] Fig. 4A is a perspective diagram showing a configuration of a semiconductor device according to a fourth embodiment of the present invention.

[Fig. 4B] Fig. 4B is a cross-sectional diagram taken in the line X-X' of the semiconductor device shown in Fig. 4A.

[Fig. 4C] Fig. 4C is a cross-sectional diagram showing when a gate trench is formed in the substrate, according to the fourth embodiment.

[Fig. 4D] Fig. 4D is a cross-sectional diagram showing when a first drift region and a second drift region are formed on the substrate, according to the fourth embodiment.

[Fig. 4E] Fig. 4E is a cross-sectional diagram showing when a well region, a source region, and a drain region are formed on a substrate, according to the fourth embodiment.

[Fig. 4F] Fig. 4F is a cross-sectional diagram showing when a gate insulating film and a gate electrode are formed in the gate trench, according to the fourth embodiment.

[Fig. 4G] Fig. 4G is a cross-sectional diagram showing a configuration of a semiconductor device according to a second modified example of the fourth embodiment of the present invention.

[Fig. 4H] Fig. 4H is a cross-sectional diagram showing a configuration of a semiconductor device according to a fourth modified example of the fourth embodiment of the present invention.

[Fig. 4I] Fig. 4I is a cross-sectional diagram showing a configuration of a semiconductor device according to a fifth modified example of the fourth embodiment of the present invention.

[Fig. 4J] Fig. 4J is a cross-sectional diagram showing a configuration of a semiconductor device according to a sixth modified example of the fourth embodiment of the present invention.

[Fig. 4K] Fig. 4K is a cross-sectional diagram showing a configuration of a semiconductor device according to a seventh modified example of the fourth embodiment of the present invention.

[Fig. 4L] Fig. 4L is a cross-sectional diagram showing a configuration of a semiconductor device according to an eighth modified example of the fourth embodiment of the present invention.

[Fig. 4M] Fig. 4M is a cross-sectional diagram showing a configuration of a semiconductor device according to a ninth modified example of the fourth embodiment of the present invention.

[Fig. 5A] Fig. 5A is a perspective diagram showing a configuration of a semiconductor device according to a fifth embodiment of the present invention.

[Fig. 5B] Fig. 5B is a cross-sectional diagram taken in the line X-X' of the semiconductor device shown in Fig. 5A.

[Fig. 5C] Fig. 5C is a cross-sectional diagram showing when ions are implanted in the substrate, according to the fifth embodiment.

[Fig. 5D] Fig. 5D is a plan view showing when a plurality of semiconductor devices respectively including column region are provided side by side, according to the fifth embodiment.

DESCRIPTION OF EMBODIMENTS

Hereinafter, embodiments of the present invention will now be explained with reference to the drawings. The same or similar elements in the following explanations of the drawings are indicated by the same or similar reference numerals. In the embodiments of the present invention, "a first conductivity type" and "a second conductivity type" are opposite conductivity types to each other. Namely, when the first conductivity type is an N-type, the second conductivity type is a P-type, and when the first conductivity type is a P-type, the second conductivity type is an N-type. The present invention will be illustrated with an example in which the first conductivity type is an N-type and the second conductivity type is a P-type; however, the first conductivity type may be a P-type and the second conductivity type may be an N-type instead. When the N-type and the P-type are switched to each other, a polarity of applied voltage is also reversed.

Moreover, the cross-sectional diagrams of the semiconductor device shown in the present embodiment have exaggeratingly described the distance in a depth direction (an up-and-down direction in the drawings) in order to promote understanding. In other words, a scale in a right-left direction and a scale of an up-and-down direction in the diagrams are not identical with each other. Furthermore, illustrations of electrode wirings are omitted.

[Explanation of First Embodiment]

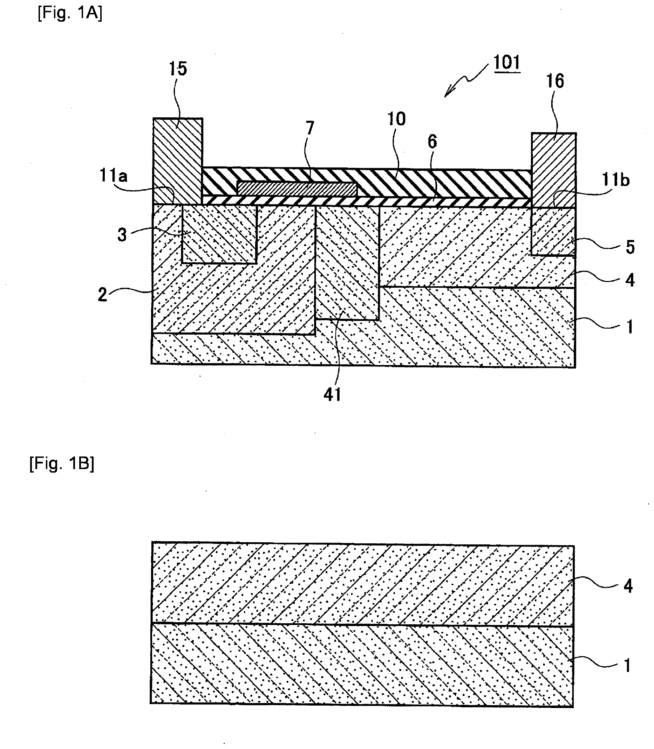

Fig. 1A is a cross-sectional diagram showing a configuration of a semiconductor device according to a first embodiment of the present invention. The present embodiment explains a Metal Oxide Semiconductor Field Effect Transistor (MOSFET) as an example of the semiconductor device.

As shown in Fig. 1A, a semiconductor device 101 according to the first embodiment includes: a substrate 1; and an N-type first drift region 4, an N-type second drift region 41, and a P-type well region 2 which are formed on a first main surface of the substrate 1. The semiconductor device 101 includes an N+-type source region 3 formed to extend from a surface of the well region 2 in a direction perpendicular thereto to the inside of the well region 2. The semiconductor device 101 includes an N+-type drain region 5 formed to extend from a surface of the first drift region 4 to the inside of the first drift region 4 and to be separated from the well region 2. The semiconductor device 101 further includes a gate electrode 7 in contact with a source region 3, the well region 2, and the second drift region 41 via a gate insulating film 6. The gate insulating film 6 is formed in contact with the second drift region 41, the well region 2, and the source region 3. An interlayer insulating film 10 is formed on a surface of the gate insulating film 6.

The contact holes 11a, 11b are formed in the interlayer insulating film 10. A source electrode 15 is formed in contact with the source region 3 and the well region 2 through the contact hole 11a. A drain electrode 16 is formed in contact with the drain region 5 through the contact hole 11b.

The substrate 1 has a thickness of several tens to several hundreds of micrometers. As the substrate 1, a semi-insulating substrate or an insulating substrate can be used, for example. The insulating substrate shown herein corresponds to a substrate of which a resistivity is several kΩ/cm or more. As a material of the substrate 1, silicon carbide (SiC) having high insulating performance can be used. The present embodiment explains an example using the substrate 1 formed of silicon carbide. Silicon carbide has several polytypes (polymorphism). The present embodiment is illustrated with an example of using silicon carbide of a common 4H polytype.

The first drift region 4 and the second drift region 41 have a thickness of several to several tens of micrometers, and the second drift region 41 reaches deeper than (below in the drawing) the first drift region. An impurity concentration of the first drift region 4 and the second drift region 41 is higher than that of the substrate 1, and is within a range from $1\times10^{14}$ to $1\times10^{18}$/cm³, for example. A material of the first drift region 4 and the second drift region 41 can be used as the same material as the substrate 1.

The well region 2 is formed to extend from the surface (upper side surface thereof in the drawing) of the substrate 1 towards a direction perpendicular to a surface of the second drift region 41. The well region 2 is formed so as to be deeper than the second drift region 41. An impurity concentration of the well region 2 is within a range from $1\times10^{15}$ to $1\times10^{19}$/cm³, for example.

The source region 3 is formed to extend from a surface of the well region 2 in a direction perpendicular to the surface of the well region 2 into the well region 2. The source region 3 has the same conductivity type as the second drift region 41. An impurity concentration of the source region 3 is higher than that of the second drift region 41, and is within a range from $1\times10^{18}$ to

$1 \times 10^{21}/cm^3$, for example.

The source electrode 15 is formed in contact with the surface of the source region 3 and the surface of the well region 2. The source region 3 and well region 2 and the source electrode 15 are electrically connected to each other, and the source region 3 has the same electric potential as the well region 2. As a material of the source electrode 15, nickel (Ni), titanium (Ti), or molybdenum (Mo) can be used, for example.

The drain region 5 is formed to extend to the inside of the first drift region 4 from the surface of the first drift region 4 in the direction perpendicular to the surface of the first drift region 4. The drain region 5 has the same conductivity type as the first drift region 4. An impurity concentration of the drain region 5 is of the same degree as that of the source region 3, and is within a range from $1 \times 10^{18}$ to $1 \times 10^{21}/cm^3$, for example.

The drain electrode 16 is electrically connected to the drain region 5. As a material of the drain electrode 16, nickel (Ni), titanium (Ti), or molybdenum (Mo) can be used, as in the above-mentioned case of the source electrode 15.

As a material of the gate insulating film 6, silicon oxide ($SiO_2$ film) can be used, for example. As a material of the gate electrode 7, N-type polysilicon can be used, for example.

[Manufacturing Method of First Embodiment]

Next, the manufacturing method of the semiconductor device 101 according to the first embodiment will now be explained. First, N-type impurities are ion-implanted in a first main surface of a non-doped silicon carbide insulated semiconductor substrate (substrate 1) to form the first drift region 4. Consequently, as shown in Fig. 1B, the first drift region 4 formed of N--type silicon carbide is formed on the upper surface of the substrate 1.Nitrogen can be used as the N-type impurities. An implantation concentration thereof is within a range from $1 \times 10^{14}$ to $1 \times 10^{18}/cm^3$. A thickness of the first drift region 4 can be adjusted in accordance with energy of the ion implantation. In the present embodiment, the thickness thereof is equal to or less than several micrometers.

Next, the second drift region 41, the well region 2, the source region 3, and the drain region 5 are formed in the first drift region 4 shown in Fig. 1B by means of the ion implantation method. Although the order to form them is not in particular to be limited, it is preferable to form the second drift region 41 and the well region 2 in advance. The source region 3 and the drain region 5 may be simultaneously formed.

In order to pattern the ion-implanted region when forming the above-mentioned second drift region 41, well region 2, source region 3, and drain region 5, processing shown hereinafter is performed.

A mask material (not illustrated) is deposited on the surface of the first drift region 4. A silicon oxidation film can be used as the mask material, and as a deposition method, a thermal CVD method and a plasma CVD method can be used.

Subsequently, a resist is patterned on a surface of the mask material. As a patterning method, a general photolithography method can be used. The mask material is etched by using the patterned resist as a mask. As an etching method, wet etching using hydrofluoric acid (HF) or dry etching such as reactive ion etching can be used.

Subsequently, the resist is removed by means of oxygen plasma, sulfuric acid, or the like. P-type impurities and N-type impurities are ion-implanted by means of the mask material as a mask, to form the N-type second drift region 41, the P-type well region 2, and the N+-type source region 3. As the P-type impurities, aluminum or boron can be used. Nitrogen can be used as the N-type impurities. At this time, such ions are implanted in a state where the substrate is heated up to approximately 600°C, whereby a crystal defect can be suppressed from occurring in the implanted region.

The mask material is removed by etching using fluorinated acid, for example, after the ion implantation. Next, the impurities thus ion-implanted are activated by performing heat treatment therefor. The heat treatment is preferable to be performed at approximately 1700°C and preferably under an argon or nitrogen atmosphere.

Moreover, an impurity concentration of the source region 3 and the drain region 5 formed in the above-mentioned procedure is preferable to be within a range from $1 \times 10^{18}/cm^3$ to $1 \times 10^{21}/cm^3$. Moreover, an impurity concentration of the well region 2 is preferable to be within a range from $1 \times 10^{15}/cm^3$ to $1 \times 10^{19}/cm^3$, and an implantation depth of the well region 2 is deeper than that of the first drift region 4.

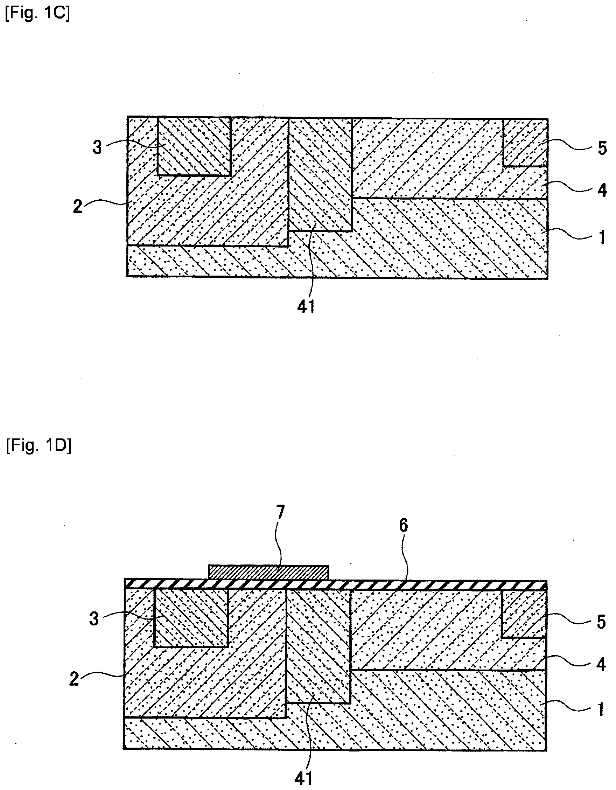

An impurity concentration of the second drift region 41 is preferable to be identical with that of the first drift region 4, and the second drift region 41 is formed to be deeper than the first drift region 4. Implantation energy when forming the second drift region 41 is preferable to be equal to or greater than a MeV level for example, if the thickness of the first drift region 4 is equal to or greater than 1 micrometer. Fig. 1C shows a cross-sectional structure after forming the second drift region 41, the well region 2, the source region 3, and the drain region 5.

Subsequently, the gate insulating film 6 is formed on the first main surface of the substrate 1. As a method of forming the gate insulating film 6, a thermal oxidation method or a deposition method can be used.

As an example of the thermal oxidation method, the substrate 1 is disposed under an oxygen atmosphere and is heated to approximately 1100°C. A silicon oxide film can be formed at all the portions where the substrate 1 is contacted with oxygen. The gate insulating film 6 thus formed may be subjected to annealing at approximately 1000°C under an atmosphere of nitrogen, argon or $N_2O$ in order to decrease an interfacial level at the interface between the well region 2 and the gate insulating film 6.

Moreover, it is also possible as another example of the thermal oxidation method to thermally oxidize directly under an atmosphere of nitrogen monoxide (NO) or dinitrogen monoxide ($N_2O$). The temperature in that case is preferable to be within a range from 1100°C to 1400°C. The thickness of the gate insulating film 6 to be formed is preferable to be several tens of nanometers.

Next, the gate electrode 7 is formed on the surface of the gate insulating film 6. The material of which the gate electrode 7 is formed is commonly polysilicon, and an example of depositing the polysilicon will now be explained in the present embodiment. A low pressure CVD method can be used as the deposition method of polysilicon. A thickness is not in particular limited when depositing the polysilicon, but is preferable to be approximately 1 micrometer. The deposited polysilicon is then subjected to annealing in phosphoryl chloride ($POCl_3$) at approximately 950°C so as to form N-type polysilicon and provide the gate electrode 7 with electric conductivity.

Subsequently, the polysilicon of the gate electrode 7 is subjected to etching. Isotropic etching or anisotropic selective etching may be used as an etching method. Resist may be used as a mask for the etching. Consequently, as shown in Fig. 1D, the gate electrode 7 in contact with the well region 2, the source region 3, and the second drift region 41 via the gate insulating film 6 is formed.

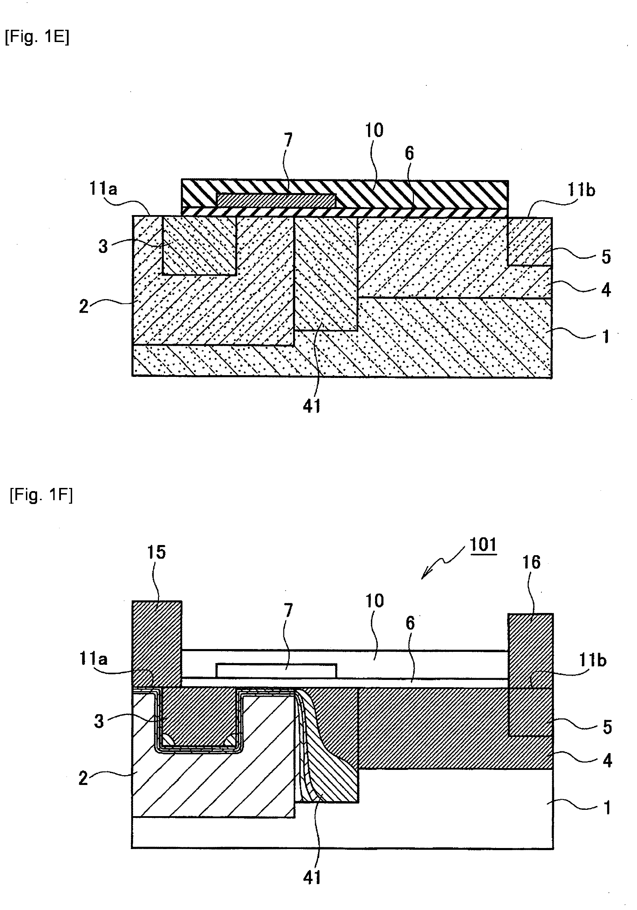

Next, the interlayer insulating film 10 is formed on the surface of the gate electrode 7 and the surface of the gate insulating film 6. Furthermore, the contact holes 11a, 11b used for the electrodes are formed. Fig. 1E is a cross-sectional diagram after forming the interlayer insulating film 10 and the contact holes 11a, 11b.

As the interlayer insulating film 10, it is generally preferable to use a silicon oxide film, and a thermal CVD method or a plasma CVD method can be used as a forming method thereof. The thickness of the interlayer insulating film 10 is preferable to be equal to or greater than 1 micrometer.

Subsequently, a resist (not illustrated) is patterned on the interlayer insulating film 10. As a patterning method, a general photolithography method can be used. The patterned resist is used as a mask so as to subject the interlayer insulating film 10 to etching. As an etching method, wet etching using hydrofluoric acid and dry etching such as reactive ion etching can be used. The contact holes 11a, 11b are formed in the interlayer insulating film 10. The contact hole 11a used for the source electrode 15 is formed so that the well region 2 and the source region 3 are simultaneously exposed therefrom. The resist is removed by means of oxygen plasma, sulfuric acid, or the like.

After forming the contact holes 11a, 11b, the source electrode 15 and the drain electrode 16 are formed. As an electrode material, a metal is generally used. As mentioned above, Ti, Ni, Mo, or the like can be used as such a metal. Alternatively, a laminated metal, e.g. Ti / Ni / Ag, may be used therefor. An example of using titanium (Ti) will now be explained in the present embodiment. First, a deposition method, e.g. a sputtering method, is used to deposit titanium (Ti). Subsequently, selective etching by means of a resist mask is subjected to the deposited titanium. Consequently, the semiconductor device 101 of the first embodiment shown in Fig. 1A is completed.

[Explanation of Operation of First Embodiment]

Next, an operation of the semiconductor device 101 according to the first embodiment shown in Fig. 1A will now be explained. The semiconductor device 101 controls a voltage of the gate electrode 7 in a state where a positive voltage is applied to the drain electrode 16 while taking a voltage of the source electrode 15 as a reference, and thereby functions as a transistor.

In other words, when a voltage between the gate electrode 7 and the source electrode 15 reaches equal to or greater than a predetermined threshold, an inversion layer is formed in a channel of the well region 2 so as to be turned ON. Then, the current thus flows from the drain electrode 16 to the source electrode 15.

More specifically, electrons flow from the source electrode 15 to the source region 3 and further flow into the second drift region 41 via the channel. Next, the electrons flow into the drain electrode 16 through the first drift region 4 and the drain region 5. In other words, the current flows from the drain electrode 16 to the source electrode 15.

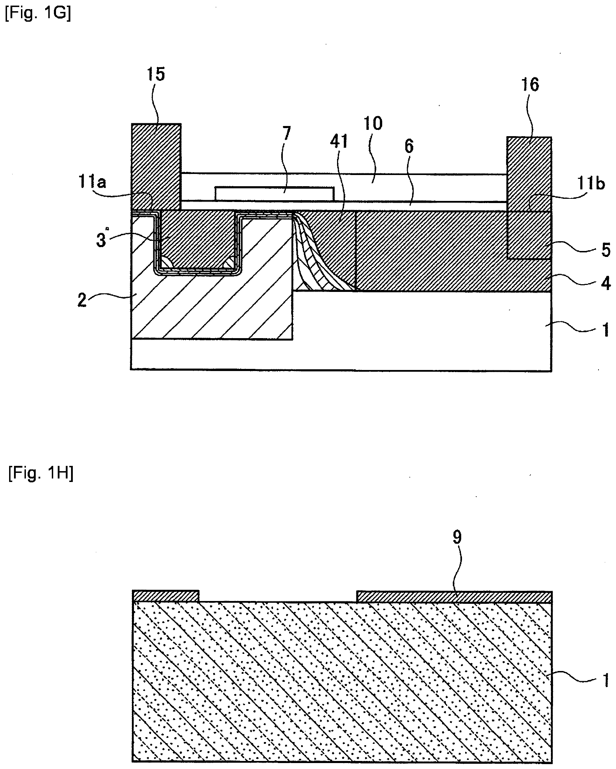

Fig. 1F is an explanatory diagram showing a current density when the electrons flow from the source region 3 into the second drift region 41, the first drift region 4, and the drain region 5 through the channel formed in the well region 2. On the other hand, Fig. 1G is an explanatory diagram showing a current density in a case of forming no second drift region 41. In Figs. 1F and 1G, the higher the current density, the denser the hatching is shown.

In Fig. IF, the second drift region 41 is formed to be so deep, and thereby a region having a high current density extends. On the other hand, in Fig. 1G, a region where having a low current density extends since the second drift region 41 is not formed. Accordingly, it is understood that the flow path of the current widens and a resistance eventually is reduced, by providing the second drift region 41.

Meanwhile, when the voltage between the gate electrode 7 and the source electrode 15 is set at the predetermined threshold voltage or less, the inversion layer disappears, and it is turned to an OFF state, and the current is interrupted. At this time, a high voltage of several hundreds to several thousands of volts is applied between the drain electrode 16 and the source electrode 15. However, since breakdown voltage performance is high, the OFF state can be maintained.

In the semiconductor device 101 according to the present embodiment, the depletion layer by a PN junction between the N-type second drift region 41 and the P-type well region 2 extends at the time of conduction. A region through which no electrons flow into a part of the second drift region 41 is formed, the region through which the electrons flow narrows, and the resistance is increased. However, since the second drift region 41 is formed to be deeper than the first drift region 4, the flow path of the electrons after passing through the channel widens, and thereby the resistance is reduced. In other words, the resistance at the time of conduction can be reduced as compared with the case where merely the first drift region 4 is formed without providing the second drift region 41 as conventional.

In the present embodiment, silicon carbide (SiC) is used as a material of the substrate 1. Since silicon carbide has high insulating performance are high thermal conductivity, the substrate 1 can efficiently be cooled by attaching a cooler (not illustrated) on a back side surface of the substrate 1 via a conductive material. In other words, a heat generated due to a current which flows when the semiconductor device 101 is turned ON can efficiently radiate. Moreover, since silicon carbide is a semiconductor having a wide bandgap and has few intrinsic carriers, the semiconductor device effectively exerting high insulating performance. Accordingly, the semiconductor device having high breakdown voltage can be provided.

In the present embodiment, since the substrate 1 is a semi-insulating substrate or an insulating substrate, there is no necessary to provide the insulating material between the semiconductor device and the cooler, when cooling the semiconductor device. Accordingly, the cooling performance thereof can be improved and the substrate 1 can easily be attached to the cooler. Moreover, since the substrate 1 is a semi-insulating substrate or an insulating substrate, the substrate 1 and the drain electrode 16 do not have the same electric potential, when the semiconductor device 101 is turned OFF. Accordingly, since the electric field is not applied from the substrate 1 to the well region 2 or gate electrode 7 by the drain voltage as compared with the case where the conductive substrate is used, it becomes possible to improve the breakdown voltage.

The wideband gap semiconductor, e.g. silicon carbide (SiC), are used as the substrate 1. Since the wideband gap semiconductor has high thermal conductivity, the heat generated when the semiconductor device is the ON state can efficiently radiate. Consequently, the semiconductor device having high cooling performance can be provided. Moreover, since the wideband gap semiconductor has few intrinsic carriers, the insulating property can be improved.

In the manufacturing method of the present embodiment, the impurities are implanted into the substrate 1 by means of the ion implantation method, and are activated by heat treatment, to form the first drift region 4 and the second drift region 41. Accordingly, the conventional epitaxial growth becomes unnecessary and thereby

by the costs can be reduced.

Furthermore, since the impurities are implanted thereinto by means of the ion implantation method to form the first drift region 4 and the second drift region 41, the depth and concentration of the first drift region 4 and the second drift region 41 can be easily designed. Moreover, flexibility of design is high and thereby the manufacturing costs can be reduced.

[Modified Example of First Embodiment]

Next, a modified example of the first embodiment will now be explained. In the modified example of the first embodiment, the second drift region 41 has an impurity concentration lower than an impurity concentration of the first drift region 4. The other configuration is the same as that of the first embodiment shown in Fig. 1A. A manufacturing method thereof is the same as that of the above-mentioned first embodiment.

Hereinafter, an operation of a semiconductor device according to the modified example of the first embodiment will now be explained. An operation at the time of conduction is the same as that of the first embodiment. When the semiconductor device is turned OFF and a current is interrupted, a depletion layer extends in the second drift region 41 and the first drift region 4 from the well region 2 as a voltage of the drain electrode 16 is increased. Therefore, an electric field is generated from the drain electrode 16 to the well region 2. At this time, since the gate electrode 7 has the same electric potential as the well region 2, the electric field is generated between the gate electrode 7 and the drain electrode 16. Therefore, an electric field concentration is caused at an edge of the gate electrode 7 in contact with the second drift region 41, and the breakdown voltage is reduced.

In the modified example of the first embodiment, intensity of the electric field generated at the edge of the gate electrode 7 can be reduced by decreasing the impurity concentration of the second drift region 41. Accordingly, the breakdown voltage can be improved. In other words, the semiconductor device having high breakdown voltage and low resistance can be provided.

Next, another method of forming the first drift region 4 and the second drift region 41 will now be explained. First, a mask material 9 is deposited on the substrate 1, and is patterned. Consequently, the cross-sectional structure shown in Fig. 1H is formed. The mask material 9 shown in Fig. 1H is preferable to be a silicon oxide film, and it is preferable to use a thermal CVD method or a plasma CVD method as the deposition method. A thickness of the mask material 9 is determined on the basis of a difference between a depth of the second drift region 41 and a depth of the first drift region 4.

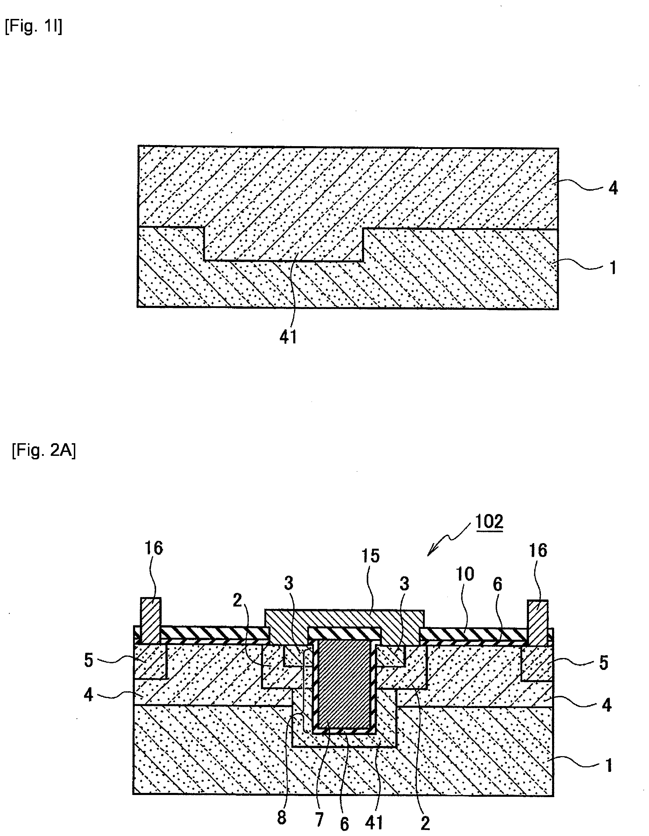

Next, the first drift region 4 and the second drift region 41 can be simultaneously formed by implanting N-type impurity ions. A concentration of the impurities to be implanted is preferable to be within a range from $1 \times 10^{14}$ to $1 \times 10^{18}/cm^3$. Fig. 1I is an explanatory diagram showing a cross-sectional structure after implanting the impurity ions.

Since the first drift region 4 and the second drift region 41 can be simultaneously formed by one ion implantation by means of this method, the manufacturing costs can be reduced.

Moreover, when the first drift region 4 has the same impurity concentration as the second drift region 41, the first drift region 4 and the second drift region 41 can be simultaneously formed. Since both of the first drift region 4 and the second drift region 41 can be simultaneously formed by one ion implantation at the time when implanting the impurities by ion implantation, the procedure of manufacturing can be simplified. Accordingly, the manufacturing costs can be reduced.

[Explanation of Second Embodiment]

Next, a second embodiment of the present invention will now be explained. Fig. 2A is a cross-sectional diagram showing a structure of a semiconductor device according to the second embodiment.

As shown in Fig. 2A, the semiconductor device 102 according to the second embodiment includes: a substrate 1; and an N-type first drift region 4 and an N-type second drift region 41 which are formed on a first main surface of the substrate 1. The second drift region 41 is formed substantially at the center in one direction (right-left direction in the drawing) parallel to the first main surface of the substrate 1. The second drift region 41 is formed so as to be deeper than the first drift region 4.

A P-type well region 2 formed in an inside of the second drift region 41 and the first drift region 4 so as to extend from the surfaces thereof in a direction perpendicular to the surfaces thereof. The well region 2 is formed to a position shallower than that of the first drift region 4. An N+-type source region 3 formed to extend from a surface of the well region 2 in a direction perpendicular thereto to an inside of the well region 2. A gate trench 8 is formed so as to pass through from the source region 3 to the second drift region 41. In other words, the gate trench 8 is formed in contact with the second drift region 41.

N+-type drain regions 5 are respectively formed at edges (right and left edges in the drawing) in one direction parallel to the first main surface of the substrate 1.

A gate insulating film 6 is formed on an inner surface of the gate trench 8. Furthermore, the gate insulating film 6 is also formed similarly on surfaces of the first drift region 4, the well region 2, and the source region 3. A gate electrode 7 is formed in the inside of the gate trench 8 via the gate insulating film 6. In other words, the gate electrode 7 is in contact with the well region 2, the source region 3, and the second drift region 41, via the gate insulating film 6.

An interlayer insulating film 10 is formed on a surface of the gate insulating film 6 formed on the surfaces of the first drift region 4, the well region 2, and the source region 3. A drain electrode 16 in contact with the drain region 5 is formed so as to pass through the interlayer insulating film 10 and the gate insulating film 6. A source electrode 15 in contact with the well region 2 and the source region 3 is formed so as to pass through the interlayer insulating film 10 and the gate insulating film 6. The source region 3 and the well region 2 are in contact with the source electrode 15. Accordingly, the source region 3 has the same electric potential as the well region 2.

An insulating substrate or a semi-insulating substrate can be used as the substrate 1. The substrate 1 has a thickness of several tens to several hundreds of micrometers. The insulating substrate shown herein corresponds to a substrate of which a resistivity is several $k\Omega/cm$ or more. As a material of the substrate 1, silicon carbide (SiC) which is an insulating substrate can be used. In the present embodiment, an example of the case where the substrate 1 is silicon carbide will now be explained. Silicon carbide has several polytypes (polymorphism). The present embodiment is illustrated with an example of using silicon carbide of a common 4H polytype.

The first drift region 4 and the second drift region 41 have a thickness of several to several tens of micrometers, and the second drift region 41 is formed so as to be deeper than the first drift region 4. An impurity concentration of the first drift region 4 and the second drift region 41 is higher than that of the substrate 1, and is within a range from $1\times10^{14}$ to $1\times10^{18}/cm^3$, for example. A material of the first drift region 4 and the second drift region 41 can be used as the same material as the substrate 1.

The well region 2 is formed in the second drift region 41 so as to extend towards a direction perpendicular to the surface (upper side surface in the drawing) of the second drift region 41 from the surface of the second drift region 41. The well region 2 is formed so as to be deeper than the second drift region 41. An impurity concentration of the well region 2 is within a range from $1\times10^{15}$ to $1\times10^{19}/cm^3$, for example.

The source region 3 is formed in the well region 2 so as to extend from a surface of the well region 2 in a direction perpendicular to the surface of the well region 2. The source region 3 has the same conductivity type as the second drift region 41. An impurity concentration of the source region 3 is higher than that of the second drift region 41, and is within a range from $1\times10^{18}$ to $1\times10^{21}/cm^3$, for example.

The source electrode 15 is formed in contact with the surface of the source region 3 and the surface of the well region 2. The source region 3 and the well region 2, and the source electrode 15 are electrically connected to one another. Accordingly, the source region 3 has the same electric potential as the well region 2. As a material of the source electrode 15, nickel (Ni), titanium (Ti), or molybdenum (Mo) can be used, for example.

The drain region 5 is formed to extend from the surface of the first drift region 4 in a direction perpendicular to the surface thereof. The drain region 5 has the same conductivity type as the first drift region 4. An impurity concentration of the drain region 5 is of the same degree as that of the source region 3, and is within a range from $1\times10^{18}$ to $1\times10^{21}$/cm$^3$, for example.

The drain electrodes 16 are connected to the drain region 5. As a material of the drain electrodes 16, nickel (Ni), titanium (Ti), or molybdenum (Mo) can be used, as in the above-mentioned case of the source electrode 15.

As a material of the gate insulating film 6, a silicon oxide film can be used, for example. As a material of the gate electrode 7, N-type polysilicon can be used, for example.

[Manufacturing Method of Second Embodiment]

Next, the manufacturing method of the semiconductor device 102 according to the second embodiment will now be explained. First, a mask material (not illustrated) is formed on a non-doped silicon carbide semiconductor substrate (substrate 1). A silicon oxidation film can be used as the mask material, and as a deposition method, a thermal CVD method and a plasma CVD method can be used.

Next, a resist is patterned on the mask material. As a patterning method, a general photolithography method can be used. The mask material is etched by using the patterned resist as a mask. As an etching method, wet etching using hydrofluoric acid and dry etching such as reactive ion etching can be used.

The resist is then removed by use of oxygen plasma or sulfuric acid. The mask material is used as the mask, P-type impurities and N-type impurities are ion-implanted, to form the P-type well region 2, the N+-type source region 3, and the N+-type drain region 5.

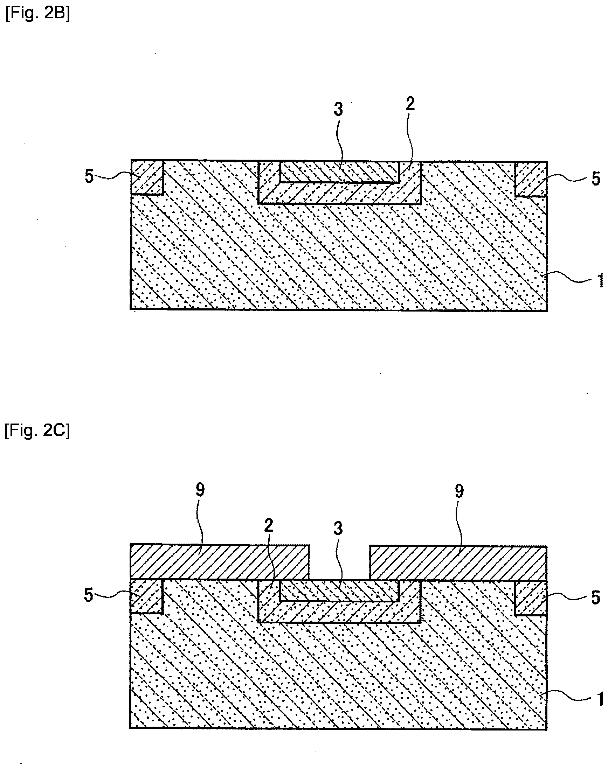

As the P-type impurities, aluminum or boron can be used. As the N-type impurities, nitrogen can be used. At this time, such ions are implanted in a state where the substrate 1 is heated up to approximately 600°C, whereby a crystal defect can be suppressed from occurring in the implanted region. The mask material is removed by etching using fluorinated acid, after performing the ion implantation. Fig. 2B shows a cross-sectional structure after performing the ion implantation.

An impurity concentration of the source region 3 and the drain region 5 formed by the above-mentioned method is preferable to be within a range from $1\times10^{18}$/cm$^3$ to $1\times10^{21}$/cm$^3$. Moreover, an impurity concentration of the well region 2 is preferable to be within a range of $1\times10^{15}$/cm$^3$ to $1\times10^{19}$/cm$^3$.

Next, as shown in Fig. 2C, a mask material 9 for forming the gate trench 8 (refer to Fig. 2A) is formed and patterned. A silicon oxidation film can be used as the mask material 9, and as a deposition method, a thermal CVD method and a plasma CVD method can be used.

As a patterning method, a general photolithography method can be used. The mask material 9 is etched by using the patterned resist as a mask. As an etching method, wet etching using hydrofluoric acid and dry etching such as reactive ion etching can be used.

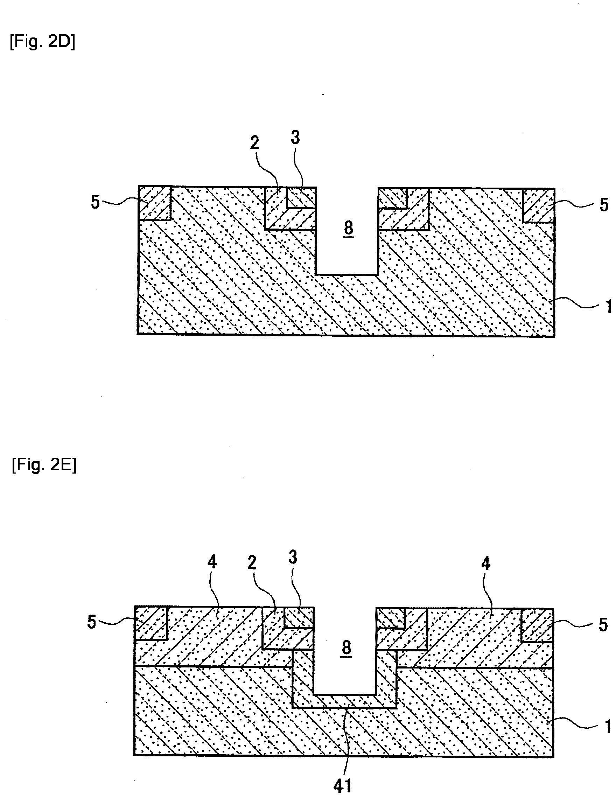

Then, the mask material 9 is used as a mask to form the gate trench 8. As a method of forming the gate trench 8, it is preferable to use a dry etching method. After forming the gate trench 8, the mask material 9 is removed. For example, when the mask material 9 is a silicon oxide film, the mask material 9 is removed by hydrofluoric acid cleaning. Fig. 2D shows a cross-sectional structure after forming the gate trench 8 and then removing the mask material 9.

Subsequently, the first drift region 4 and the second drift region 41 are formed. In the cross-sectional structure shown in Fig. 2D, the first drift region 4 and the second drift region 41 can be simultaneously formed by obliquely ion-implanting the N-type impurities. An implantation concentration thereof is preferable to be within a range from $1\times10^{14}$ to $1\times10^{18}$/cm$^3$. Implantation energy can be set in accordance with depths of the first drift region 4 and the second drift region 41. For example, in the case where the depth of the first drift region 4 is 1 micrometer, the N-type impurities are implanted with the implantation energy on the order of MeV. An implantation angle is set as an angle such that a bottom of the gate trench 8 is completely surrounded by the N-type region. If the width of the gate trench 8 is 1 micrometer and the depth is 1 micrometer, it is preferable to set the implantation angle to equal to or less than 45 degrees. Fig. 2E shows a cross section after forming the first drift region 4 and the second drift region 41.

Next, the impurities thus ion-implanted are activated by performing heat treatment therefor. The heat treatment is preferable to be performed at approximately 1700°C and preferably under an argon or nitrogen atmosphere.

Then, the gate insulating film 6 is formed on an inner surface of the gate trench 8. As a method of forming the gate insulating film 6, a thermal oxidation method or a deposition method can be used. As an example of the thermal oxidation method, the substrate 1 is disposed under an oxygen atmosphere and is heated to approximately 1100°C. A silicon oxide film can be formed at all the portions where the substrate 1 is contacted with oxygen. The gate insulating film 6 thus formed may be subjected to annealing at approximately 1000°C under an atmosphere of nitrogen, argon or N$_2$O in order to decrease an interfacial level at the interface between the well region 2 and the gate insulating film 6.

Moreover, it is also possible as another example of the thermal oxidation method to thermally oxidize directly under an atmosphere of nitrogen monoxide (NO) or dinitrogen monoxide (N$_2$O). The temperature in that case is preferable to be within a range from 1100°C to 1400°C. The thickness of the gate insulating film 6 to be formed is preferable to be several tens of nanometers.

Next, the gate electrode 7 is formed in the gate trench 8. The material of which the gate electrode 7 is formed is commonly polysilicon, and an example of depositing the polysilicon will now be explained in the present embodiment. A low pressure CVD method can be used as the deposition method of polysilicon. A thickness of the polysilicon to be deposited is set to be larger than the half of the width of the gate trench 8. Thus, the gate trench 8 is completely filled up with the polysilicon. For example, when the width of the gate trench 8 is 2 micrometers, the deposition thickness of the polysilicon is thicker than 1 micrometer.

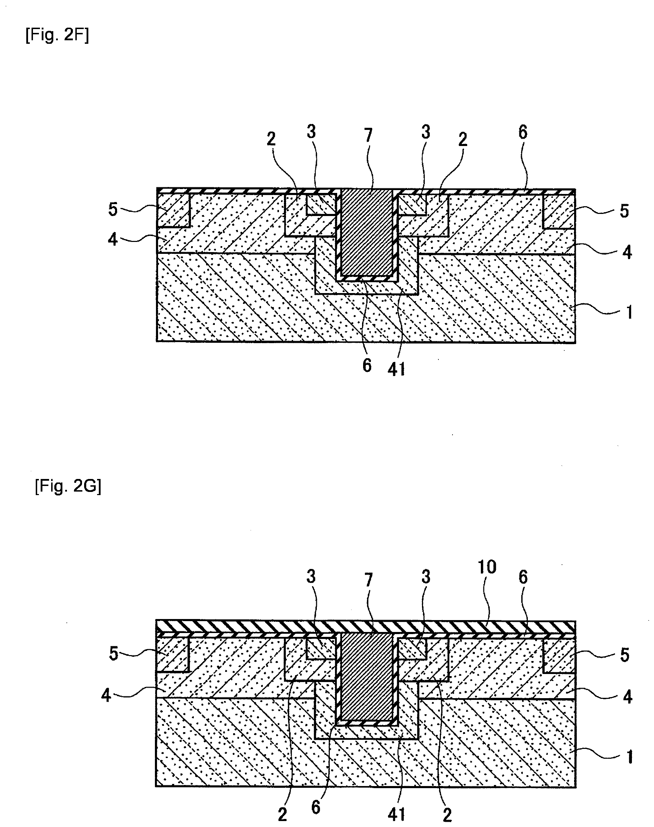

The deposited polysilicon is then subjected to annealing in $POCl_3$ at approximately 950°C so as to form N-type polysilicon and provide the gate electrode 7 with electric conductivity. Next, the polysilicon 23 of the gate electrode 7 is subjected to etching. The etching performed may be either isotropic etching or anisotropic etching. An amount of the etching is set so that the polysilicon remains in the inside of the gate trench 8. For example, when the width of the gate trench 8 is 2 micrometers, and the polysilicon is deposited with the thickness of 1.5 micrometers, the etching amount is preferably 1.5 micrometers. In addition, several percent of overetching with respect to the polysilicon with the thickness of 1.5 micrometers is a permissible level for the etching. Fig. 2F shows the cross-sectional structure after performing the etching.

Next, the interlayer insulating film 10 is formed on the surface of the substrate 1. The interlayer insulating film 10 is generally preferably a silicon oxide film and may be deposited by a thermal CVD method or a plasma CVD method. The thickness of the interlayer insulating film 10 is preferable to be equal to or greater than 1 micrometer. Fig. 2G shows a cross-sectional structure after forming the interlayer insulating film 10.

After forming the interlayer insulating film 10, contact holes (not illustrated) for the source electrode 15 and the drain electrodes 16 are formed. In this process, a resist is patterned on the interlayer insulating film 10 (not illustrated). As a patterning method, a general photolithography method can be used. The patterned resist is used as a mask so as to subject the interlayer insulating film 10 to etching. As an etching method, wet etching using hydrofluoric acid and dry etching such as reactive ion etching can be used. The resist is then removed by use of oxygen plasma or sulfuric acid. From the contact hole for source electrode 15, the well region 2 and the source region 3 are simultaneously exposed.

After forming the contact holes, the source electrode 15 and the left and right drain electrodes 16 are formed, as shown in Fig. 2A. As an electrode material, a metal is generally used. As such a metal, titanium (Ti), nickel (Ni), or molybdenum (Mo) can be used. Alternatively, a laminated metal, e.g. Ti / Ni / Ag, may be used therefor. An example of using titanium (Ti) will now be explained in the present embodiment. Firstly, the titanium (Ti) is deposited. TA sputtering method is preferred for a deposition method as an example. By implementing selective etching by means of the resist mask with respect to the deposited titanium, the semiconductor device 102 according to the second embodiment shown in Fig. 2A is completed.

[Explanation of Operation of Second Embodiment]

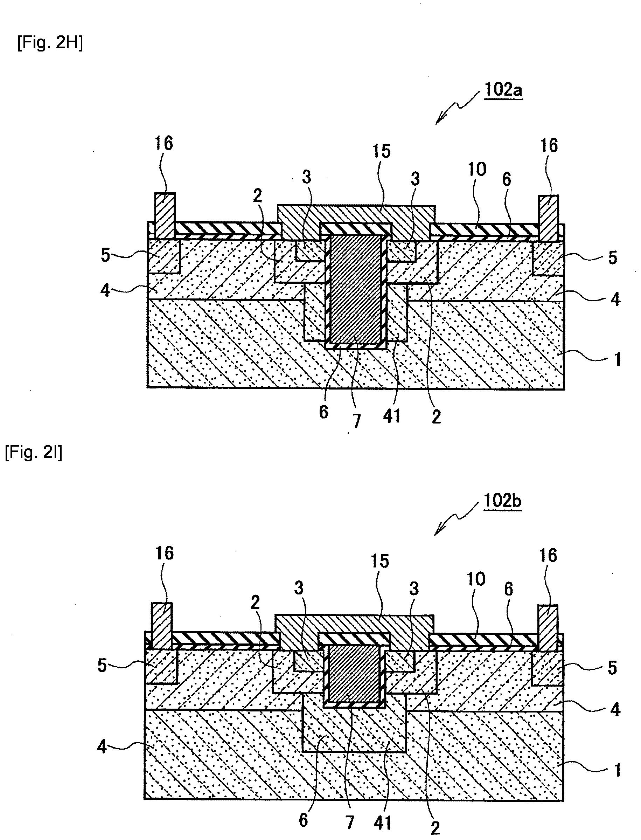

An operation of the semiconductor device 102 according to the second embodiment shown in Fig. 2A will now be explained. The semiconductor device 102 shown in Fig. 2 controls a voltage of the gate electrode 7 in a state where a positive voltage is applied to the drain electrode 16 while taking a voltage of the source electrode 15 as a reference, and thereby functions as a transistor.

In other words, when a voltage between the gate electrode 7 and the source electrode 15 reaches equal to or greater than a predetermined threshold, an inversion layer is formed in a channel of the well region 2 which is present on the side surface of the gate electrode 7 so as to be turned ON. The current flows from the drain electrode 16 to the source electrode 15. More specifically, electrons flow from the source electrode 15 to the source region 3 and further flow into the second drift region 41 via the channel. Furthermore, the electrons flow into the first drift region 4, and further flow from the first drift region 4 into the drain region 5 and the drain electrode 16.

Meanwhile, when the voltage between the gate electrode 7 and the source electrode 15 is set at the predetermined threshold voltage or less, the inversion layer disappears, and it is turned to an OFF state, and the current is interrupted. At this time, a high voltage of several hundreds to several thousands of volts is applied between the drain electrode 16 and the source electrode 15. However, since breakdown voltage performance is high, the OFF state can be maintained.

In the present embodiment, the depletion layer by the PN junction extends in the first drift region 4 and the well region 2 at the time of conduction, and a region through which no electrons flow into a part of the first drift region 4 is formed. Therefore, the region through which the electrons flow narrows, and the resistance is increased. However, since the second drift region 41 is formed to be deeper than the first drift region 4, the flow path of the electrons after passing through the channel widens, and thereby the resistance is reduced. Moreover, since the gate trench 8 is formed so as to be deeper than the first drift region 4, the formed second drift region 41 can be formed deeper, and thereby the region through which the current flows can be widened. Therefore, the resistance can be further reduced.

Moreover, since the substrate 1 made from silicon carbide (SiC) is used, the insulating performance and the thermal conductivity of the substrate 1 can be improved. Accordingly, cooling efficiency can be improved by directly attaching the back side surface of the substrate 1 to a cooler (not illustrated) via the conductive materials.

Furthermore, since the thermal conductivity of the substrate 1 is high, a heat generated due to the current which flows can efficiently radiate. Moreover, since the wideband gap semiconductor using silicon carbide has few intrinsic carriers, it is easy to realize high insulating performance. Accordingly, the semiconductor device having high breakdown voltage can be provided.

Moreover, in the present embodiment, the gate trench 8 is formed and the gate electrode 7 is formed in the inside of the gate trench 8. Therefore, since the area of the unit cell can be made smaller than that in the case of a planer type gate electrode, the chip can be miniaturized, and the costs can be reduced.

Furthermore, in the present embodiment, since the gate trench 8 is formed in the second drift region 41, when the semiconductor device 102 is turned to ON, a positive bias higher than that to the second drift region is applied to the gate electrode 7. Therefore, electrons are accumulated in the sidewall of the gate trench 8 to be highly concentrated, and the current flows along the sidewall on the second drift region 41. Furthermore, a width of the current extends in the second drift region 41 and the first drift region 4. Therefore, the current flow path can be widened and the resistance can be reduced.

Moreover, since the second drift region 41 is formed after forming the gate trench 8, the depth of the second drift region 41 is formed to be the total depth of the depth of the gate trench 8 and the implantation depth of the second drift region. For example, if the depth of the gate trench 8 is 1 micrometer and the implantation depth of the second drift region 41 is 0.2 micrometer, the depth of the second drift region is formed to be 1.2 micrometers. Accordingly, since the second drift region 41 can deeply be formed with low implantation energy, the implantation energy can be reduced, and eventually the manufacturing cost can be reduced.

Moreover, since the first drift region 4 and the second drift region 41 are formed by implanting ions into the substrate 1, epitaxial growth is unnecessary and thereby the manufacturing costs can be reduced.

[First Modified Example of Second Embodiment]

Next, a first modified example of a semiconductor device according to the second embodiment will now be explained. A device configuration is the same as that of the second embodiment shown in Fig. 2A. In the first modified example of the second embodiment, the second drift region 41 has an impurity concentration lower than an impurity concentration of the first drift region 4. The other configuration is the same as that of the above-mentioned second embodiment. A manufacturing method is the same as the method shown in the second embodiment.

Hereinafter, an operation of the semiconductor device according to the first modified example of the second embodiment will now be explained. An operation in the ON state is the same as that of the second embodiment.

When the semiconductor device is in the OFF state and a current is interrupted, a depletion layer extends in the second drift region 41 and the first drift region 4 from gate electrode 7 as a voltage of the drain electrode 16 is increased, and therefore, an electric field is generated from the drain electrode 16 to the well region 2. Since the impurity concentration of the second drift region 41 is lower than the impurity concentration of the first drift region 4, the electric field generated in the gate electrode 7 can be reduced. In other words, the breakdown voltage can be improved and the resistance can be reduced.

[Second Modified Example of Second Embodiment]

Next, a second modified example of the second embodiment will now be explained. Fig. 2H is a cross-sectional diagram showing a configuration of a semiconductor device according to the second modified example of the second embodiment. The semiconductor device 102a shown in Fig. 2H is different from the semiconductor device 102 shown in Fig. 2A mentioned above in a point that the gate trench 8 is formed to be deeper than the second drift region 41 and is reached at the insulating substrate.

A manufacturing method in the second modified example is different from the manufacturing method of the semiconductor device 102 shown in Fig. 2A in a point of the angle of the obliquely implanting of the impurities when forming the first drift region 4 and the second drift region 41. More specifically, in the case of the semiconductor device 102a shown in Fig. 2H, the implantation angle is set so that the impurities are not implanted into the bottom of the gate trench 8. For example, if the width of the gate trench 8 is 1 micrometer and the depth is 1 micrometer, it is preferable to set the implantation angle to equal to or larger than 45 degrees.

Hereinafter, an operation of the semiconductor device 102a according to the second modified example will now be explained. An operation in the ON state is the same as that of the above-mentioned second embodiment. In the OFF state where the current is interrupted, since the edge portion of the gate electrode 7 (i.e., the corner portion of the bottom of the gate trench 8) is in contact with the insulating substrate, the electric field concentration caused at the corner portion is suppressed. Accordingly, the high breakdown voltage can be realized.

Moreover, an electrostatic capacitance generated at the bottom of the gate trench 8 between the gate electrode 7 and the second drift region 41 can be reduced. Therefore, the electrostatic capacitance (Cgd) between the gate and the drain of the semiconductor device 102a can be reduced, and the semiconductor device capable of high-speed operation can be provided.

[Third Modified Example of Second Embodiment]

Next, a third modified example of the second embodiment will now be explained. Fig. 2I is a cross-sectional diagram showing a configuration of a semiconductor device according to the third modified example of the second embodiment. The semiconductor device 102b shown in Fig. 2I is different from the semiconductor device 102 shown in Fig. 2A mentioned above in a point that the gate trench 8 is formed shallower than the first drift region 4.

A manufacturing method in the third modified example is different from the manufacturing method of the semiconductor device 102 shown in Fig. 2A in a point that after forming the well region 2, the source region 3, and the drain region 5, the first drift region 4 and the second drift region 41 are formed by means of ion implantation, and then the gate trench 8 is formed in the second drift region 41.

An operation of the semiconductor device 102b according to the third modified example is substantially the same as that of the semiconductor device 102 according to the second embodiment mentioned above. In the third modified example, obliquely implanting of the impurities is unnecessary in the manufacturing process, and it can shorten the etching time for forming the gate trench 8. Consequently, the manufacturing process can be shortened and the manufacturing costs can be reduced.

[Explanation of third Embodiment]

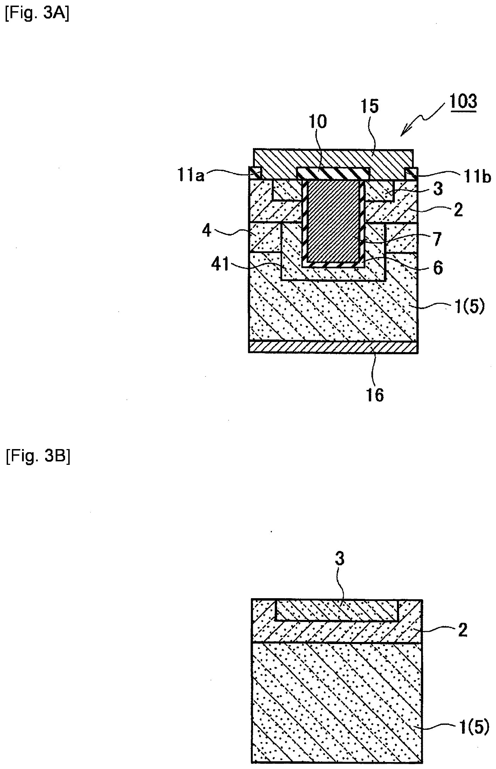

Next, a third embodiment of the present invention will now be explained. Fig. 3A is a cross-sectional diagram showing a configuration of a semiconductor device according to the third embodiment.

As shown in Fig. 3A, the semiconductor device 103 according to the third embodiment includes: an N-type first drift region 4 and a N-type second drift region 41 which are formed on a first main surface of an N-type electrical conductivity semiconductor substrate (substrate 1). In the same manner to the above-mentioned first and second embodiments, the first drift region 4 and the second drift region 41 are contacted with each other, and the second drift region 41 is formed to be deeper than the first drift region 4.

A P-type well region 2 is formed on a surface of the first drift region 4 and a surface of the second drift region 41. The semiconductor device 103 includes an N+-type source region 3 formed to extend from a surface of the well region 2 in a direction perpendicular thereto to the inside of the well region 2.

A gate trench 8 is formed so as to pass through the well region 2 and the source region 3 and to reach the second drift region 41. A gate insulating film 6 is formed on an inner surface of the gate trench 8, and a gate electrode 7 is further formed in the inside thereof. The gate electrode 7 is in contact with the well region 2, the source region 3, and the second drift region 41, via the gate insulating film 6. The gate trench 8 is formed to be deeper than the first drift region 4.

An interlayer insulating film 10 is formed on surfaces of the well region 2, the source region 3, and the gate electrode 7. The contact holes 11a, 11b are formed in the interlayer insulating film 10. A source electrode 15 is formed on a surface of the interlayer insulating film 10, and the source electrode 15 is in contact with the well region 2 and the source region 3, via the contact holes 11a, 11b.

Since a silicon carbide semiconductor (SiC) substrate is used as a material of the substrate 1 and N-type impurities are further ion-implanted thereinto, the substrate 1 is also made as a drain region 5. The source region 3 and the well region 2 are in contact with the source electrode 15 and therefore the source region 3 has the same electric potential as the well region 2. A drain electrode 16 is formed on a second main surface of the substrate 1.

Moreover, an impurity concentration of the substrate 1 is preferable to be within a range of $1\times10^{18}/cm^3$ to $1\times10^{19}/cm^3$. Silicon carbide (SiC) has several polytypes (polymorphism). The present embodiment is illustrated with an example of using silicon carbide of a common 4H polytype.

[Manufacturing Method of Third Embodiment]

Next, the manufacturing method of the semiconductor device 103 according to the third embodiment will now be explained. First, the P-type well region 2 and the N+-type source region 3 are formed by means of ion implantation on the silicon carbide semiconductor substrate (substrate 1). A cross-sectional structure after forming the well region 2 and the source region 3 is shown in Fig. 3B. Impurity concentrations of the source region 3 and the drain region 5 are preferable to be within a range from $1\times10^{18}/cm^3$ to $1\times10^{21}/cm^3$. Moreover, the concentration of the well region 2 is preferable to be within a range from $1\times10^{15}/cm^3$ to $1\times10^{19}/cm^3$.

Next, in order to form the gate trench 8, a mask material (not illustrated) is formed and then is patterned. A silicon oxidation film can be used as the mask material, and as a deposition method, a thermal CVD method and a plasma CVD method can be used. As a patterning method, a general photolithography method can be used. The mask material is etched by using the patterned resist as a mask. As an etching method, wet etching using hydrofluoric acid and dry etching such as reactive ion etching can be used.

Then, the mask material is used as a mask to form the gate trench 8. As a method of forming the gate trench 8, a dry etching method can be used. After forming the gate trench 8, the mask material is removed. For example, when the mask material is a silicon oxide film, the mask material 9 is removed by hydrofluoric acid cleaning.

After forming the gate trench 8, the first drift region 4 and the second drift region 41 are formed. The first drift region 4 and the second drift region 41 are simultaneously formed by obliquely ion implantation. The implantation concentration of impurities is preferable to be within a range from $1 \times 10^{14}$ to $1 \times 10/^{18}$ cm$^3$. Implantation energy is set in accordance with depths of the first drift region 4 and the second drift region 41. An implantation angle is set as an angle such that a bottom of the gate trench 8 is completely surrounded by the N-type region.

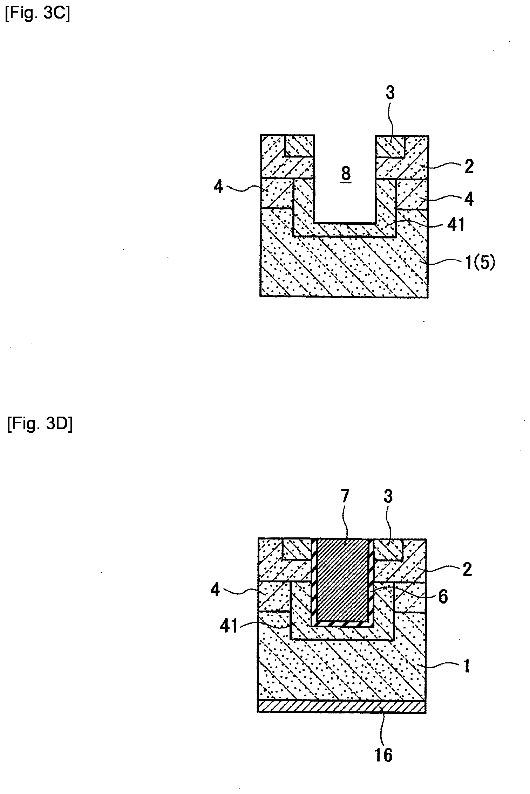

For example, in the case where the depth of the first drift region 4 is 1 micrometer, implanting of the N-type impurities on the order of MeV is required. If the width of the gate trench 8 is 1 micrometer and the depth is 1 micrometer, it is preferable to set the implantation angle of the impurities to equal to or less than 45 degrees. Using P-type impurity ions, it is implanted so that the concentration of the substrate 1 is inverted. For example, if the concentration of the first drift region 4 and the second drift region 41 is $1 \times 10^{17}$/cm$^3$ and the concentration of the substrate 1 is $1 \times 10^{18}$/cm$^3$, it is preferable to implant the P-type impurity ions of which the concentration is $9 \times 10^{17}$/cm$^3$ thereinto. Fig. 3C shows a cross-sectional structure after forming the first drift region 4 and the second drift region 41.

Next, the gate insulating film 6 is formed on the inner surface of the gate trench 8. As a method of forming the gate insulating film 6, a thermal oxidation method or a deposition method can be used. As an example of the thermal oxidation method, the substrate 1 is disposed under an oxygen atmosphere and is heated to approximately 1100°C. A silicon oxide film can be formed at all the portions where the substrate 1 is contacted with oxygen. The gate insulating film 6 thus formed may be subjected to annealing at approximately 1000°C under an atmosphere of nitrogen, argon or $N_2O$ in order to decrease an interfacial level at the interface between the well region 2 and the gate insulating film 6.

Moreover, it is also possible as another example of the thermal oxidation method to thermally oxidize directly under an atmosphere of nitrogen monoxide (NO) or dinitrogen monoxide ($N_2O$). The temperature in that case is preferable to be within a range from 1100°C to 1400°C. The thickness of the gate insulating film 6 to be formed is preferable to be several tens of nanometers.

Then, the gate electrode 7 is formed on the inside of the gate trench 8 in which the gate insulating film 6 is formed. The material of which the gate electrode 7 is formed is commonly polysilicon, and an example of depositing the polysilicon will now be explained in the present embodiment. A low pressure CVD method can be used as the deposition method of polysilicon. A thickness of the polysilicon to be deposited is set to be larger than the half of the width of the gate trench 8. Thus, the gate trench 8 can completely be filled up with the polysilicon. For example, when the width of the gate trench 8 is 2 micrometers, the deposition thickness of the polysilicon is thicker than 1 micrometer. The deposited polysilicon is then subjected to annealing in POCl$_3$ at approximately 950°C so as to form N-type polysilicon and provide the gate electrode 7 with electric conductivity.

Subsequently, the polysilicon 23 of the gate electrode 7 is subjected to etching. The etching performed may be either isotropic etching or anisotropic etching. An amount of the etching is set so that the polysilicon remains in the inside of the gate trench 8. For example, when the width of the gate trench 8 is 2 micrometers, and the polysilicon is deposited with the thickness of 1.5 micrometers, the etching amount is preferably 1.5 micrometers. In addition, several percent of overetching with respect to the polysilicon with the thickness of 1.5 micrometers is a permissible level for the etching. Fig. 3D shows a cross-sectional structure after performing the etching.

Next, the interlayer insulating film 10 (refer to Fig. 3A) is formed. The interlayer insulating film 10 is generally preferably a silicon oxide film and may be formed by a thermal CVD method or a plasma CVD method. The thickness of the interlayer insulating film 10 is preferable to be equal to or greater than 1 micrometer. After forming the interlayer insulating film 10, the contact holes 11a, 11b for connecting the source electrode 15 are formed.

Subsequently, a resist (not illustrated) is patterned on the interlayer insulating film 10. As a patterning method, a general photolithography method can be used. The patterned resist is used as a mask so as to subject the interlayer insulating film 10 to etching. As an etching method, wet etching using hydrofluoric acid and dry etching such as reactive ion etching can be used. The resist is then removed by use of oxygen plasma or sulfuric acid.

The contact holes 11a, 11b for connecting the source electrode 15 are formed so that the well region 2 and the source region 3 are simultaneously exposed therefrom. After forming the contact holes 11a, 11b, the source electrode 15 is formed. Moreover, the drain electrode 16 is formed on the second main surface (lower side surface in Fig. 3D) of the substrate 1. As an electrode material, a metal is generally used. As such a metal, titanium (Ti), nickel (Ni), or molybdenum (Mo) can be used. Alternatively, a laminated metal, e.g. Ti / Ni / Ag, can be used therefor. Titanium (Ti) is used, in the present embodiment. First, a deposition method, e.g. a sputtering method, is used to deposit titanium (Ti). The deposited titanium is subjected to selective etching with a resist mask. Consequently, the semiconductor device 103 according to the third embodiment shown in Fig. 3A is completed.

[Explanation of Operation of Third Embodiment]

Next, an operation of the semiconductor device 103 according to the third embodiment will now be explained. The semiconductor device 103 having the configuration shown in Fig. 3A controls a voltage of the gate electrode 7 in a state where a positive voltage is applied to the drain electrode 16 while taking a voltage of the source electrode 15 as a reference, and thereby functions as a transistor. In other words, when a voltage between the gate electrode 7 and the source electrode 15 reaches equal to or greater than a predetermined threshold, an inversion layer is formed in a channel of the well region 2 which is in contact with the side surface of the gate electrode 7 so as to be turned ON. The current flows from the drain electrode 16 to the source electrode 15.

Specifically, electrons flow from the source electrode 15 into the source region 3. Furthermore, some electrons flow from the source region 3 into the second drift region 41 via the channel, and flow into the drain region 5 (substrate 1). The remaining electrons flow into the first drift region 4, and flow from the first drift region 4 into the drain region 5. Both electrons flow into the drain electrode 16.

Meanwhile, when the voltage between the gate electrode 7 and the source electrode 15 is set at the predetermined threshold voltage or less, the inversion layer disappears, and it is turned to an OFF state, and the current is interrupted. At this time, a high voltage of several hundreds to several thousands of volts is applied between the drain electrode 16 and the source electrode 15. However, since breakdown voltage performance is high, the OFF state can be maintained.

In the third embodiment, at the time of conduction, the second drift region 41 in the vicinity of the gate trench 8 collects electrons due to a voltage of the gate electrode 7 and becomes a high-concentration N-type region. Since the second drift region 41 is formed to be deeper than the first drift region 4 and is directly in contact with the drain region 5, the electrons which flow into the first drift region 4 flow into the drain region 5. Accordingly, an on-resistance can be reduced.

Moreover, in the present embodiment, silicon carbide (SiC) is used as the material of the substrate 1. Since silicon carbide has high insulating performance are high thermal conductivity, it can efficiently be cooled by attaching a cooler (not illustrated) on a back side surface of the substrate 1 via a conductive material. In other words, a heat generated due to a current which flows when the semiconductor device 103 is turned ON can efficiently radiate. Moreover, since silicon carbide is a semiconductor having a wide bandgap and has few intrinsic carriers, the semiconductor device effectively exerting high insulating performance. Accordingly, the semiconductor device having high breakdown voltage can be provided.

Moreover, since the first drift region 4 and the second drift region 41 are formed by implanting ions into the substrate 1, epitaxial growth is unnecessary and thereby the manufacturing costs can be reduced.

[Modified Example of Third Embodiment]

Next, a modified example of the third embodiment will now be explained. The modified example of the third embodiment is different from the third embodiment in the point that the second drift region 41 has an impurity concentration lower than an impurity concentration of the first drift region 4. The other configuration is the same as that of the third embodiment shown in Fig. 3A.

A manufacturing method in the modified example is different from the manufacturing method of the third embodiment in a point that after forming the well region 2, the source region 3, and the drain region 5, the first drift region 4 and the second drift region 41 are formed by means of ion implantation, and then the gate trench 8 is formed in the second drift region 41.

Hereinafter, an operation of a semiconductor device according to the modified example of the first embodiment will now be explained. An operation in the ON state is the same as that of the above-mentioned third embodiment. When the semiconductor device is in the OFF state, a depletion layer extends in the first drift region 4 from gate electrode 7 as a voltage of the drain electrode 16 is increased, and therefore, an electric field is generated from the drain electrode 16 to the gate electrode 7. Since the impurity concentration of the second drift region 41 is lower than the impurity concentration of the first drift region 4, intensity of the electric field generated in the gate electrode 7 can be reduced. Accordingly, the breakdown voltage can be improved. In other words, the semiconductor device having high breakdown voltage and low resistance can be provided.

[Explanation of Fourth Embodiment]

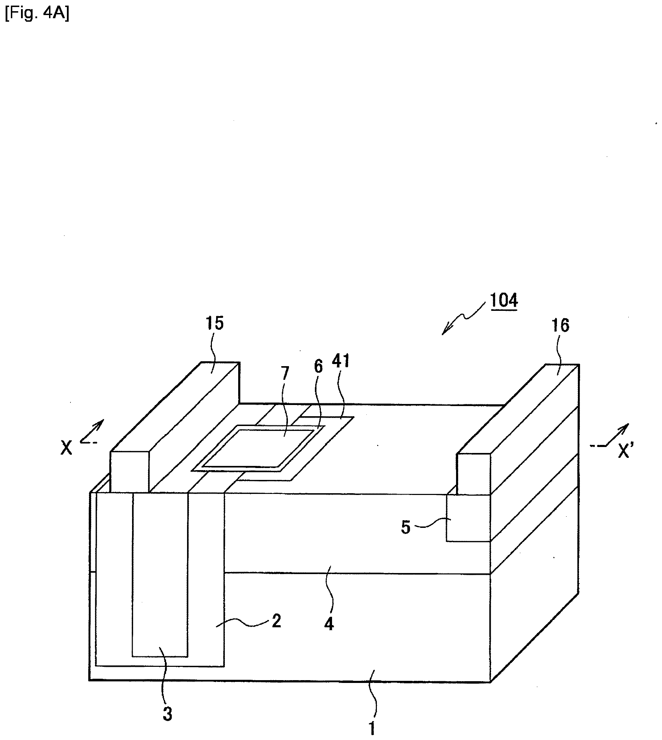

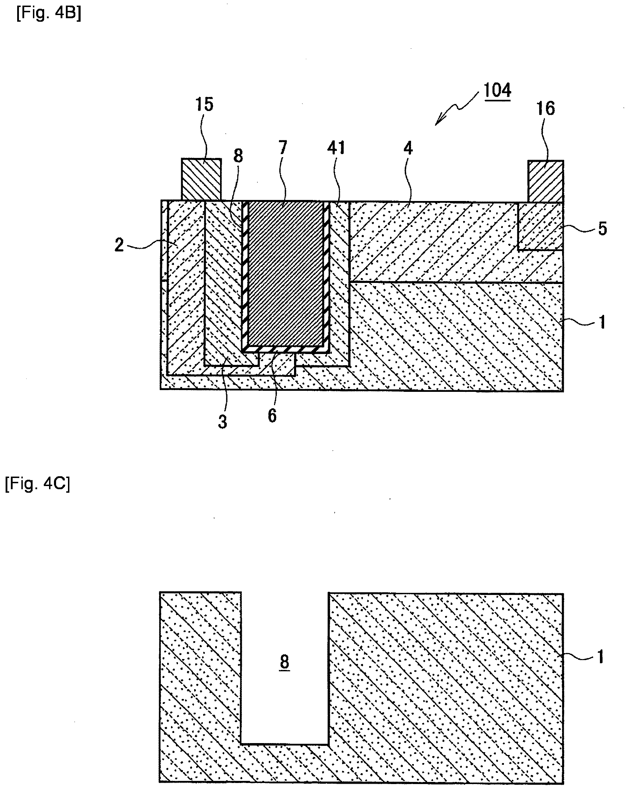

Next, a fourth embodiment of the present invention will now be explained. Fig. 4A is a perspective diagram showing a configuration of a semiconductor device according to the fourth embodiment, and Fig. 4B is a cross-sectional diagram taken in the line X-X' of Fig. 4A.

As shown in Figs. 4A and 4B, the semiconductor device 104 according to the fourth embodiment includes a substrate 1 composed of an insulating semiconductor. An N-type first drift region 4 is formed on a first main surface of the substrate 1, and a P-type well region 2 is further formed in contact with the first drift region 4. The well region 2 is formed so as to be deeper than the first drift region 4.

An N-type second drift region 41 is formed in the vicinity of a position of the first drift region 4 in contact with the well region 2. The second drift region 41 is formed so as to be deeper than the first drift region 4. An N+-type source region 3 formed to extend from a surface of the well region 2 in a direction perpendicular thereto to an inside of the well region 2.

A gate trench 8 (refer to Fig. 4B) having a rectangular shape as viewed from directly above is formed in a region over a part of the second drift region 41, a part of the well region 2, and a part of the source region 3. In other words, the gate trench 8 is in contact with the well region 2, the source region 3, and the second drift region 41. Moreover, the gate trench 8 is formed so as to be deeper than the first drift region 4. A gate insulating film 6 is formed on an inner surface of the gate trench 8, and the gate electrode 7 is further formed in the inside thereof.

A source electrode 15 is formed so as to be in contact with the surfaces of the well region 2 and the source region 3. In other words, the well region 2 has the same electric potential as the source region 3. An N+-type drain region 5 is formed at an edge of the first drift region 4, and a drain electrode 16 is further formed so as to be contact with the surface of the drain region 5. In Figs. 4A and 4B, an interlayer insulating film and contact holes are not illustrated.

Moreover, since the well region 2 is in contact with the gate insulating film 6 on a side surface of the gate trench 8, the deeper the gate trench 8 is, the larger the area in which the gate insulating film 6 and the well region 2 are in contact with each other.

As a material of the substrate 1, a semi-insulating substrate or an insulating substrate can be used, for example. The insulating substrate shown herein corresponds to a substrate of which a resistivity is several kΩ/cm or more. As a material of the substrate 1, silicon carbide (SiC) can be used. In the fourth embodiment, an example of the case where the substrate 1 is an insulating substrate formed of silicon carbide will be explained. Silicon carbide has several polytypes (polymorphism). The present embodiment is illustrated with an example of using silicon carbide of a common 4H polytype.

[Manufacturing Method of fourth Embodiment]

Next, the manufacturing method of the semiconductor device 104 according to the fourth embodiment will now be explained. First, a mask material (not illustrated) is formed on the non-doped silicon carbide insulated semiconductor substrate 1 and then is patterned in accordance with the gate trench 8. A silicon oxidation film can be used as the mask material, and as a deposition method, a thermal CVD method and a plasma CVD method can be used. As a patterning method, a general photolithography method can be used.

The mask material is etched by using the patterned resist as a mask. As an etching method, wet etching using hydrofluoric acid and dry etching such as reactive ion etching can be used.

Subsequently, using the mask material as the mask, the gate trench 8 is formed by the dry etching method. After forming the gate trench 8, the mask material is removed. For example, when the mask material is a silicon oxide film, the mask material 9 is removed by hydrofluoric acid cleaning. Fig. 4C shows a cross-sectional structure after forming the gate trench 8.

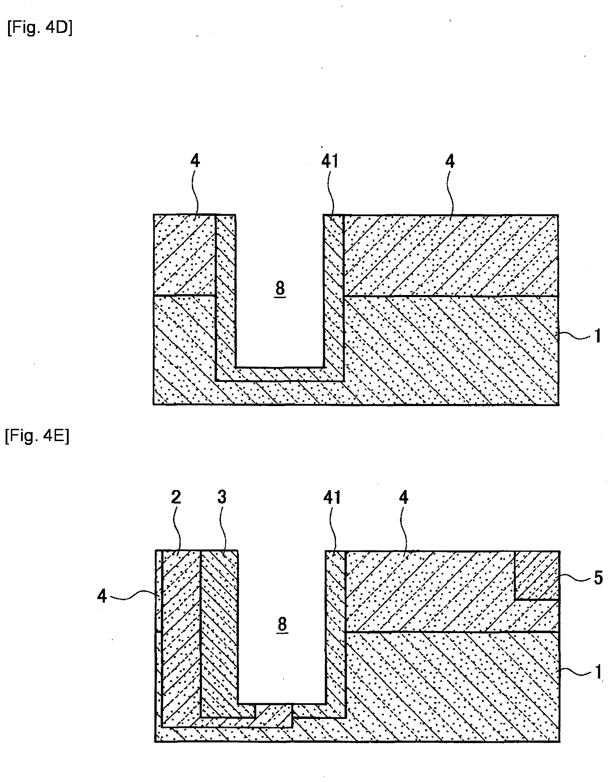

Subsequently, the first drift region 4 and the second drift region 41 are formed. In the structure shown in Fig. 4C, the first drift region 4 and the second drift region 41 can be simultaneously formed by obliquely ion-implanting the N-type impurities. An implantation concentration thereof is preferable to be within a range from $1\times10^{14}$ to $1\times10^{18}$/cm$^3$. Implantation energy is set in accordance with depths of the first drift region 4 and the second drift region 41. For example, in the case where the depth of the first drift region 4 is 1 micrometer, the N-type impurities are implanted with the implantation energy on the order of MeV. An implantation angle is set as an angle such that a bottom of the gate trench 8 is completely surrounded by the N-type region. If the width of the gate trench 8 is 1 micrometer and the depth is 1 micrometer, it is preferable to set the implantation angle to equal to or less than 45 degrees. Fig. 4D shows a cross-sectional structure after forming the first drift region 4 and the second drift region 41.

Then, the P-type well region 2, the N+-type source region 3, and the drain region 5 are formed by means of ion implantation on the substrate 1. Although the order to form them is not in particular to be limited, it is preferable to form the well region 2 in advance. Then, the source region 3 and the drain region 5 are formed. The source region 3 and the drain region 5 may be simultaneously formed. In the present embodiment, both are independently formed.

In order to pattern an ion-implanted region of the well region 2, the source region 3, and the drain region 5, a mask material (not illustrated) is formed on the first drift region 4 and the second drift region 41. A silicon oxidation film can be used as the mask material, and as a deposition method, a thermal CVD method and a plasma CVD method can be used.

Subsequently, a resist (not illustrated) is patterned on the surface of the mask material. As a patterning method, a general photolithography method can be used. The mask material is etched by using the patterned resist as a mask. As an etching method, wet etching using hydrofluoric acid (HF) or dry etching such as reactive ion etching can be used.

The resist is then removed by use of oxygen plasma or sulfuric acid. P-type impurities and N-type impurities are ion-implanted by means of the mask material as a mask, to form the P-type well region 2 and the N+-type source region 3. As the P-type impurities, aluminum or boron can be used. Nitrogen can be used as N-type impurities. At this time, such ions are implanted in a state where the substrate is heated up to approximately 600°C, whereby a crystal defect can be suppressed from occurring in the implanted region. The mask material is removed by etching using fluorinated acid, for example, after the ion implantation.

A cross-sectional structure after forming the well region 2 and the source region 3 is shown in Fig. 4E. Moreover, an impurity concentration of the source region 3 and the drain region 5 formed in the above-mentioned method is preferable to be within a range from $1\times10^{18}$/cm$^3$ to $1\times10^{21}$/cm$^3$. Moreover, an impurity concentration of the well region 2 is preferable to be within a range of $1\times10^{15}$/cm$^3$ to $1\times10^{19}$/cm$^3$. A depth of the well region 2 is preferable to be deeper than that of the gate trench 8.

Next, the impurities thus ion-implanted are activated by performing heat treatment therefor. The heat treatment is preferable to be performed at approximately 1700°C and preferably under an argon or nitrogen atmosphere.

Then, the gate insulating film 6 is formed on the inner surface of the gate trench 8 and the first main surface of the substrate 1. As a method of forming the gate insulating film 6, a thermal oxidation method or a deposition method can be used. As an example of the thermal oxidation method, the substrate 1 is disposed under an oxygen atmosphere and is heated to approximately 1100°C. A silicon oxide film can be formed at all the portions where the substrate 1 is contacted with oxygen. The gate insulating film 6 thus formed may be subjected to annealing at approximately 1000°C under an atmosphere of nitrogen, argon or $N_2O$ in order to decrease an interfacial level at the interface between the well region 2 and the gate insulating film 6.

Moreover, it is also possible as another example of the thermal oxidation method to thermally oxidize directly under an atmosphere of nitrogen monoxide (NO) or dinitrogen monoxide ($N_2O$). The temperature in that case is preferable to be within a range from 1100°C to 1400°C. The thickness of the gate insulating film 6 to be formed is preferable to be several tens of nanometers.

Next, the gate electrode 7 is formed. The material of which the gate electrode 7 is formed is commonly polysilicon, and an example of depositing the polysilicon will now be explained in the present embodiment. A low pressure CVD method can be used as the deposition method of polysilicon. A thickness of the polysilicon to be deposited is set to be larger than the half of the width of the gate trench 8. Thus, the gate trench 8 is completely filled up with the polysilicon. For example, when the width of the gate trench 8 is 2 micrometers, the deposition thickness of the polysilicon is thicker than 1 micrometer.

The deposited polysilicon is then subjected to annealing in $POCl_3$ at approximately 950°C so as to form N-type polysilicon and provide the gate electrode 7 with electric conductivity. Subsequently, the polysilicon of the gate electrode 7 is subjected to etching.

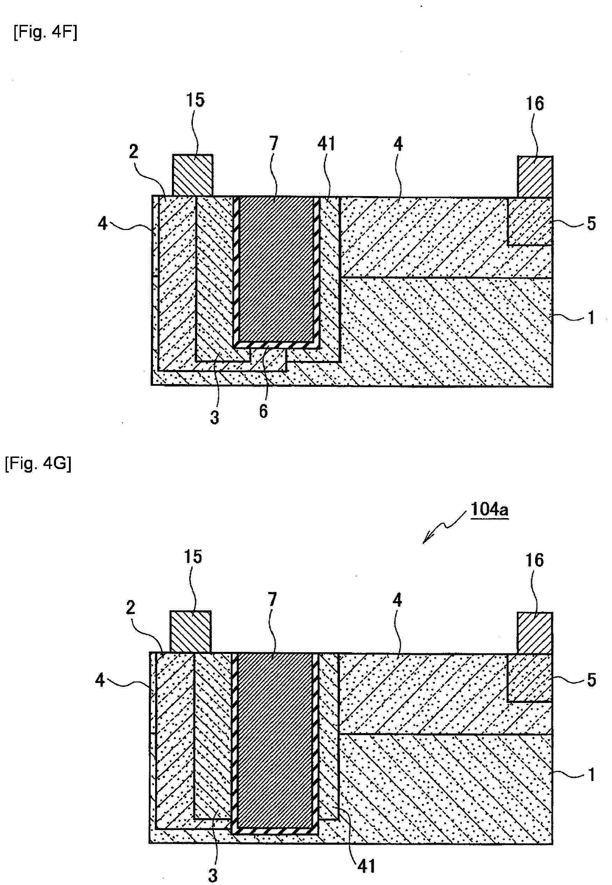

As the etching method, isotropic etching or anisotropic etching can be adopted. An amount of the etching is set so that the polysilicon remains in the inside of the gate trench 8. For example, when the width of the gate trench 8 is 2 micrometers, and the polysilicon is deposited with the thickness of 1.5 micrometers, the etching amount is preferably 1.5 micrometers. In addition, several percent of overetching with respect to the polysilicon with the thickness of 1.5 micrometers is a permissible level for the etching. Fig. 4F shows a cross-sectional structure after etching the gate electrode 7.

Next, the interlayer insulating film (not illustrated) is formed. As the interlayer insulating film, it is generally preferable to use a silicon oxide film, and a thermal CVD method or a plasma CVD method can be used as a deposition method thereof. The thickness of the interlayer insulating film is preferable to be equal to or greater than 1 micrometer. After depositing the interlayer insulating film, the contact holes for the electrodes (not illustrated) are formed. A resist (not illustrated) is patterned on the interlayer insulating film 10. As a patterning method, a general photolithography method can be used. The interlayer insulating film is etched by using patterned resist as a mask. As an etching method, wet etching using hydrofluoric acid and dry etching such as reactive ion etching can be used.

The resist is then removed by use of oxygen plasma or sulfuric acid. The contact hole used for the source electrode 15 is formed so that the well region 2 and the source region 3 are simultaneously exposed therefrom.

After forming the contact holes, the source electrode 15 is formed on the surfaces of the well region 2 and the source region 3, and the drain electrode 16 is further formed on the drain region 5, as shown in Fig. 4A. As an electrode material, a metal is generally used. As such a metal, titanium (Ti), nickel (Ni), or molybdenum (Mo) can be used. Alternatively, a laminated metal, e.g. Ti / Ni / Ag, may be used therefor. An example of using titanium (Ti) will now be explained in the present embodiment. First, a deposition method, e.g. a sputtering method, is used to deposit titanium (Ti). Subsequently, selective etching by means of a resist mask is subjected to the deposited titanium. Consequently, the semiconductor device 104 of the fourth embodiment shown in Fig. 4A is completed.

[Explanation of Operation of Fourth Embodiment]

Next, an operation of the semiconductor device 104 according to the fourth embodiment shown in Fig. 4A will now be explained. The semiconductor device 104 shown in Fig. 4A controls a voltage of the gate electrode 7 in a state where a positive voltage is applied to the drain electrode 16 while taking a voltage of the source electrode 15 as a reference, and thereby functions as a transistor.

In other words, when a voltage between the gate electrode 7 and the source electrode 15 reaches equal to or greater than a predetermined threshold, an inversion layer is formed in a channel of the well region 2 which is in contact with the side surface of the gate electrode 7 so as to be turned ON. Then, the current thus flows from the drain electrode 16 to the source electrode 15.

Specifically, electrons flow from the source electrode 15 into the source region 3. Furthermore, some electrons flow from the source region 3 into the second drift region 41 via the channel, and flow into the drain region 5. The remaining electrons flow into the first drift region 4, and flow from the first drift region 4 into the drain region 5. Both electrons flow into the drain electrode 16.

Meanwhile, when the voltage between the gate electrode 7 and the source electrode 15 is set at the predetermined threshold voltage or less, the inversion layer disappears, and it is turned to an OFF state, and the current is interrupted. At this time, a high voltage of several hundreds to several thousands of volts is applied between the drain electrode 16 and the source electrode 15. However, since breakdown voltage performance is high, the OFF state can be maintained.

In the present embodiment, it is configured so that the deeper the gate trench 8 is, the larger the area in which the gate trench 8 and the well region 2 are in contact with each other. Accordingly, since the deeper the gate trench 8 is, the wider the channel width is, and the wider the path through which the current flows is, a resistance of current which flows into the channel can be reduced. Moreover, since the second drift region 41 is formed so as to be deeper than the first drift region 4, the current path in the channel can be widened, and thereby the resistance can be reduced.

In other words, the semiconductor device 104 according to the present embodiment has depth dependency of the gate electrode 7 in addition to area dependency of the resistance, as compared with the conventional semiconductor devices. In the case of the same area, an effect of reducing the resistance can be obtained by deeply forming the gate trench 8 and by forming the gate electrode 7 deep. Accordingly, even if it is a small-sized chip, a large current can be flowed, and the chip costs can be reduced.

Moreover, in the present embodiment, silicon carbide (SiC) is used as the material of the substrate 1. Since silicon carbide has high insulating performance are high thermal conductivity, it can efficiently be cooled by attaching a cooler (not illustrated) on a back side surface of the substrate 1 via a conductive material. In other words, a heat generated due to a current which flows when the semiconductor device 104 is turned ON can efficiently radiate. Moreover, since silicon carbide is a semiconductor having a wide bandgap and has few intrinsic carriers, the semiconductor device effectively exerting high insulating performance. Accordingly, the semiconductor device having high breakdown voltage can be provided.

Moreover, since the well region 2 is deeper than the gate trench 8, the well region 2 is in contact with a bottom of the gate electrode 7. Accordingly, an electrostatic capacitance is generated between the well region 2 and the gate electrode 7 via the gate insulating film 6. This electrostatic capacitance is present in parallel to a capacitance between the gate and the source, and thereby the capacitance the between gate and the source is increased.

Wideband gap devices, e.g. silicon carbide (SiC), have larger gate-drain capacitance than that of the silicon elements, a voltage exceeding a threshold value may be momentarily applied between the gate and the source due to an unbalance between the capacitance between the gate and the source and the capacitance between the gate and the drain at the time of a switching operation. Consequently, the semiconductor device may malfunction so as to be turned ON. In the fourth embodiment, since the capacitance between the gate and the source is increased as mentioned above, the instantaneous voltage between the gate and the source at the time of the switching operation can be reduced. Accordingly, such a malfunction can be prevented.

[First Modified Example of Fourth Embodiment]

Next, the first modified example of the fourth embodiment will now be explained. The first modified example of the fourth embodiment is different from the third embodiment in the point that the second drift region 41 has an impurity concentration lower than an impurity concentration of the first drift region 4. The other configuration is the same as that of the fourth embodiment shown in Fig. 4A.

Hereinafter, the different point of the manufacturing method will now be explained. In the first modified example of the fourth embodiment, after forming the well region 2, the source region 3, and the drain region 5, the first drift region 4 and the second drift region 41 are formed by means of ion implantation. Then, the gate trench 8 is formed in the second drift region 41. The other manufacturing method is the same as that of the fourth embodiment.

Hereinafter, an operation of the first modified example of the fourth embodiment will now be explained. An operation at the time of conduction is the same as that of the above-mentioned fourth embodiment. When the semiconductor device is in the OFF state and a current is interrupted, a depletion layer extends in the second drift region 41 and the first drift region 4 from gate electrode 7 as a voltage of the drain electrode 16 is increased, and therefore, an electric field is applied from the drain electrode 16 to the well region 2. In the first modified example of the fourth embodiment, since the concentration of the second drift region 41 is made lower than the concentration of the first drift region 4, the electric field applied to the gate electrode 7 can be reduced. In other words, the breakdown voltage can be improved, and thereby the semiconductor device having high breakdown voltage and low resistance can be provided.

[Second Modified Example of Fourth Embodiment]

Next, a second modified example of a semiconductor device according to the fourth embodiment will now be explained. Fig. 4G is a cross-sectional diagram of a semiconductor device according to the second modified example of the fourth embodiment. The semiconductor device according to the second modified example is different the semiconductor device 104 shown in Fig. 4A in the point that the gate trench 8 is formed so as to be deeper than the second drift region 41, and is in contact with the insulating substrate.

A manufacturing method in the second modified example is different from the manufacturing method of the semiconductor device 104 shown in Fig. 4A in a point of the angle of the obliquely implanting of the impurities when forming the first drift region 4 and the second drift region 41. More specifically, in the case of the semiconductor device 104a shown in Fig. 4G, the angle is set so that the impurities are not implanted into the bottom of the gate trench 8. For example, if the width of the gate trench is 1 micrometer and the depth is 1 micrometer, it is preferable to set the implantation angle to equal to or larger than 45 degrees.

Hereinafter, an operation of the semiconductor device 104a according to the second modified example will now be explained. An operation in the ON state is the same as that of the above-mentioned fourth embodiment. In the OFF state where the current is interrupted, since the edge portion of the gate electrode 7 (i.e., the corner portion of the bottom of the gate trench 8) is in contact with the insulating substrate, the electric field concentration caused at the corner portion can be suppressed. Accordingly, the high breakdown voltage can be realized.

Moreover, an electrostatic capacitance generated at the bottom of the gate trench 8 between the gate electrode 7 and the second drift region 41 can be reduced. Therefore, since the electrostatic capacitance (Cgd) between the gate and the drain of the semiconductor device 104a can be reduced, the semiconductor device capable of high-speed operation can be provided.

[Third Modified Example of Fourth Embodiment]

Next, a third modified example of a semiconductor device according to the fourth embodiment will now be explained. A device configuration is the same as that shown in Fig. 4A. The different point the both is that when the source electrode 15, the gate electrode 7, and the drain electrode 16 are all at the same voltage, the second drift region 41 is completely depleted. For example, if a concentration of the second drift region 41 is $1 \times 10^{14}/cm^3$ and a distance from the gate electrode 7 to the second drift region 41 is approximately 0.1 micrometer, the second drift region 41 is completely depleted due to bending of the energy band caused by a difference of a work function between the gate electrode 7 and the second drift region 41. In other words, there is substantially no electrostatic capacitance generated by the second drift region 41 and the gate electrode 7 via the gate insulating film 6 in a region deeper than the first drift region 4. Consequently, the electrostatic capacitance (Cgd) between the gate and the drain can be reduced, high-speed operation can be realized and switching power loss can be reduced.

[Fourth Modified Example of Fourth Embodiment]

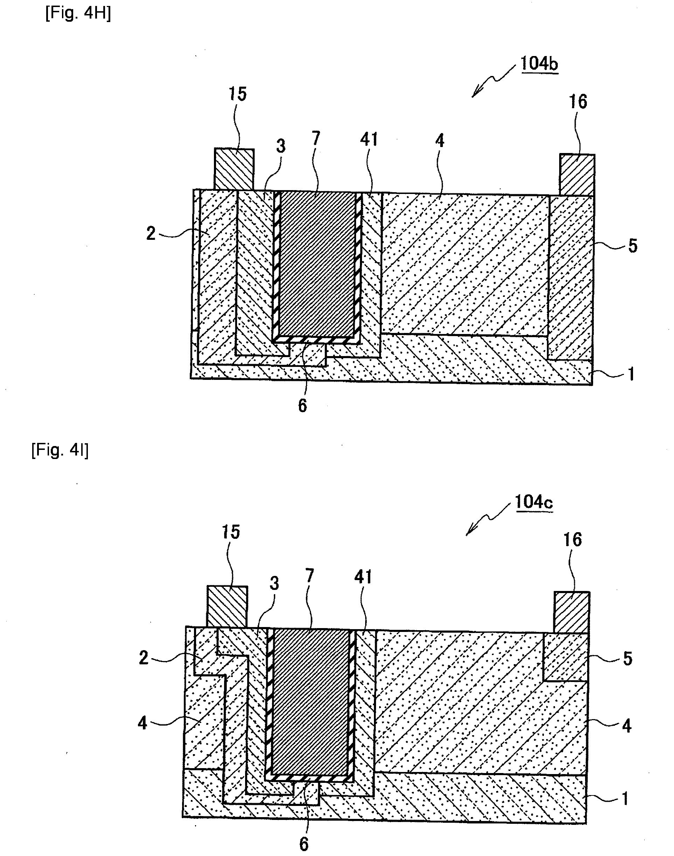

Next, a fourth modified example of a semiconductor device according to the fourth embodiment will now be explained. Fig. 4H is a cross-sectional diagram of the semiconductor device according to the fourth modified example. As shown in Fig. 4H, the semiconductor device 104b according to the fourth modified example is different from that of the fourth embodiment shown in Fig. 4A in a point that the drain region 5 is formed at the same depth as the source region 3.

By adopting such a configuration, the drain region 5 and the source region 3 can be simultaneously formed by means of ion implantation, the manufacturing process can be simplified, and the manufacturing costs can be reduced.

[Fifth Modified Example of Fourth Embodiment]

Next, a fifth modified example of a semiconductor device according to the fourth embodiment will now be explained. Fig. 4I is a cross-sectional diagram of the semiconductor device according to the fifth modified example. The semiconductor device 104c according to the fifth modified example is different from the semiconductor device 104 shown in Fig. 4A in a point that a width of the source region 3 is narrow at a position deep from the surface of the substrate 1, and the width of the source region 3 is formed widely near the surface of the substrate 1.

A different point of the manufacturing method is that the source region 3 and the well region 2 is formed by obliquely ion implantation performed into a sidewall of the gate trench 8. By adopting such a manufacturing method, even if implantation energy is low, the well region 2 and the source region 3 can deeply be formed. Therefore, the costs of the ion implantation can be reduced. Since an operation is the same as that of the fourth embodiment, an explanation thereof is omitted.

[Sixth Modified Example of Fourth Embodiment]

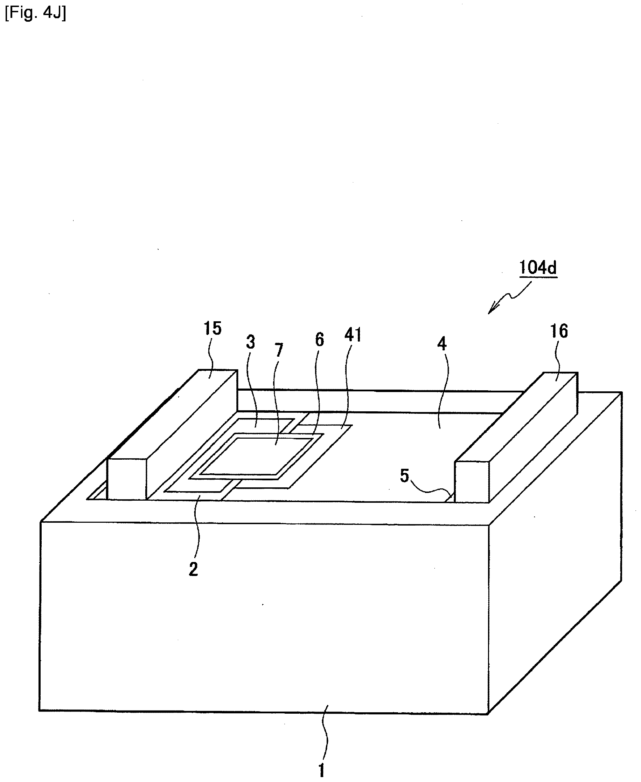

Next, a sixth modified example of a semiconductor device according to the fourth embodiment will now be explained. Fig. 4J is a perspective diagram of a semiconductor device according to the sixth modified example. The semiconductor device 104d according to the sixth modified example is different from the semiconductor device 104 shown in Fig. 4A mentioned above in that a periphery of the whole device is an insulating substrate. Moreover, a manufacturing method is different from that of the fourth embodiment in that ions are selectively implanted using a mask, in order to form the first drift region 4.

By adopting such a configuration, an electric field concentration caused at a peripheral portion can be relaxed at the time of the semiconductor device 104d being turned OFF. Conventionally, in order to relax the electric field concentration, a method of forming a guard ring in the periphery of the semiconductor device, for example has been adopted. However, if such a guard ring is formed, since the area thereof will be required, area efficiency at the time of on-operation is reduced. In the semiconductor device 104d according to the sixth modified example, the electric field concentration can be relaxed and the area efficiency can be improved. Consequently, a required current can be flowed with a small chip size, and the chip costs can be reduced.

Moreover, since no current flows into a region where the first drift region 4 is not present at the time of the on-operation, no heat is generated in this region. Therefore, since the heat generated in the first drift region 4 transfers to the region where the first drift region 4 is not present, cooling efficiency can be improved.

[Seventh Modified Example of Fourth Embodiment]

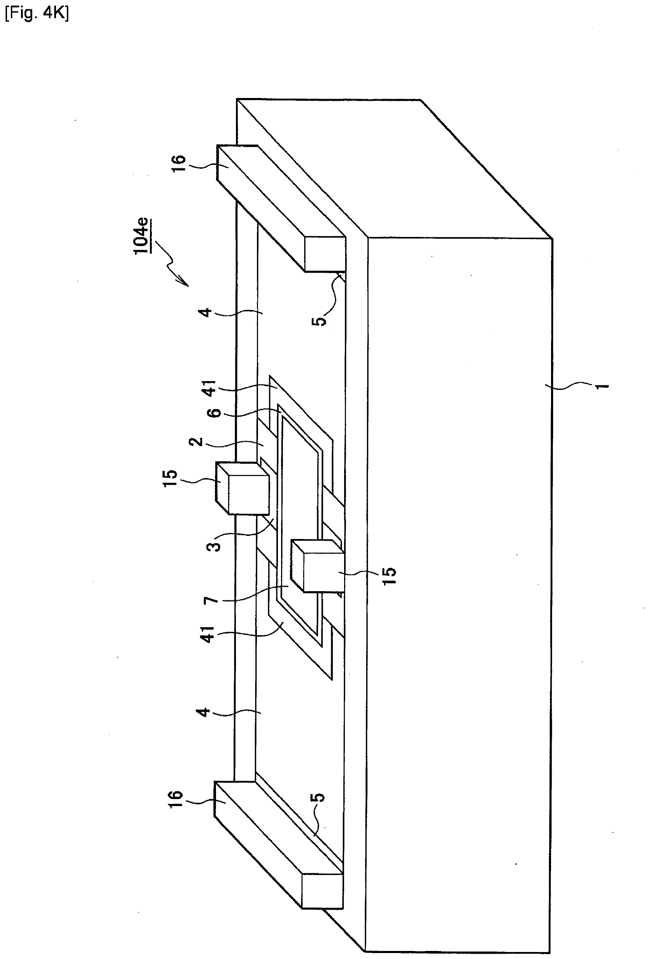

Next, a seventh modified example of a semiconductor device according to the fourth embodiment will now be explained. Fig. 4K is a perspective diagram of the semiconductor device according to the seventh modified example.

The semiconductor device 104e according to the seventh modified example is different from the semiconductor device 104 shown in Fig. 4A mentioned above in the point that a periphery of the whole device is an insulating substrate, and in the point that adjacent semiconductor devices share the gate trench and the gate electrode 7. A manufacturing method is the same as that of the fourth embodiment.

According to the seventh modified example, a variation in characteristics between a plurality of semiconductor devices can be reduced by sharing the same gate electrode 7 between the semiconductor devices which are adjacent to each other. Furthermore, area efficiency can be improved and reliability can be improved.

[Eighth Modified Example of Fourth Embodiment]

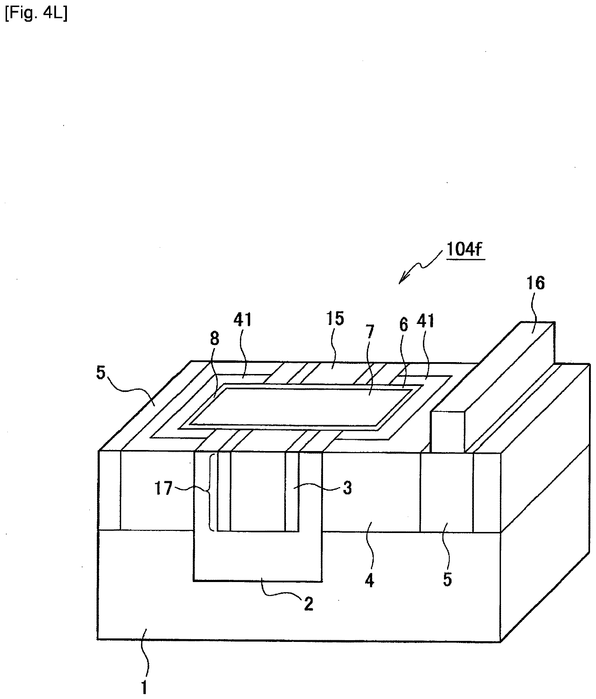

Next, an eighth modified example of a semiconductor device according to the fourth embodiment will now be explained. Fig. 4L is a perspective diagram of the semiconductor device according to the eighth modified example. As shown in Fig. 4L, the semiconductor device 104f according to the eighth modified example is different from the semiconductor device 104 shown in Fig. 4A in that the source trench 17 having the same depth as the gate trench 8 is formed in a direction orthogonal to the gate trench 8. Furthermore, the well region 2, the source region 3, and the source electrode 15 are formed in an inside of the source trench 17. The source trench 17 is formed in the direction orthogonal to the gate trench 8, viewed from directly above. A sidewall of the source trench 17 is in contact with the source region 3, and a bottom of the source trench 17 is in contact with the well region 2.

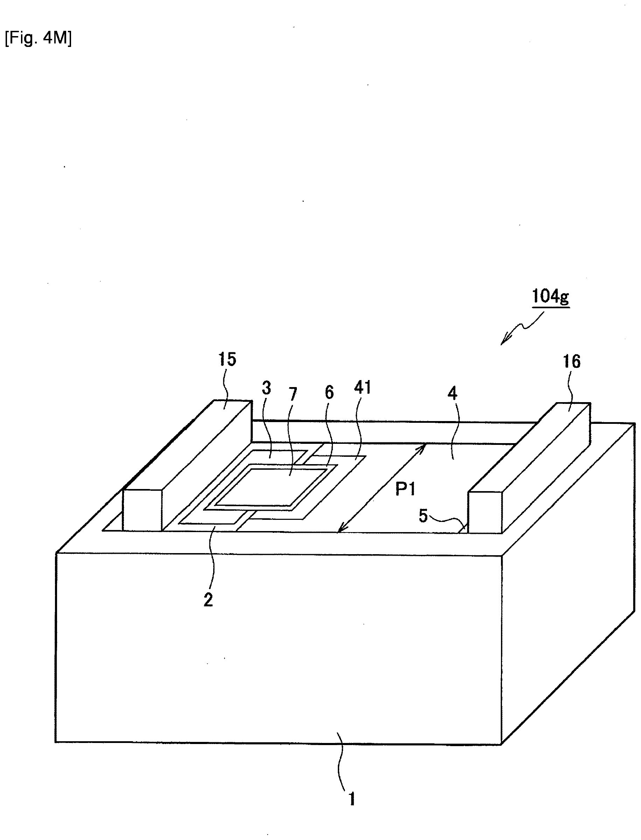

A manufacturing method thereof is different from that of the semiconductor device 104 shown in Fig. 4 in the point that the gate trench 8 and the source trench 17 are simultaneously formed, and subsequently the first drift region 4 and the second drift region 41 are formed by means of ion implantation. Then, the source region 3, the drain region 5, and the well region 2 are selectively formed using a mask. The source region 3 and the well region 2 are formed by obliquely implanting the ions into the sidewall of the source trench 17.

Moreover, in the semiconductor device 104f according to the eighth modified example, since the source electrode 15 and the source region 3 are in contact with each other on the side surface of the source trench 17, the area to be contacted can be further widened. Therefore, a contact resistance between the source electrode 15 and the source region 3 can be reduced.

Moreover, since the semiconductor device 104 shown in Fig. 4A has the configuration in which the source electrode 15 is contact with the surface of the source region 3, electrons move a long passage in the source region 3 when the semiconductor device 104 performs the on-operation. Furthermore, resistivity of the source region 3 is generally higher than a metal electrode. On the other hand, in the semiconductor device 104f according to the eighth modified example, since the source trench 17 is formed in the source region 3, the passage into which the electrons move the source region 3 can be shortened, and the resistance can be reduced.

[Ninth Modified Example of Fourth Embodiment]

Next, a ninth modified example of a semiconductor device according to the fourth embodiment will now be explained. Fig. 4M is a perspective diagram of the semiconductor device according to the ninth modified example. The semiconductor device 104g according to the sixth modified example is different from the semiconductor device 104 shown in Fig. 4A mentioned above in a point that a periphery of the whole device is an insulating substrate, as shown in Fig. 4M. Furthermore, the ninth modified example is different therefrom in a point that a depth of the gate trench 8 (refer to Fig. 4B etc.) is equal to or greater than 1/2 of the repeating pitch PI of the semiconductor device.

A manufacturing method and an operation are the same as those of the semiconductor device 104 shown with Fig. 4A. In the semiconductor device 104g according to the ninth modified example, the depth of the gate trench 8 is equal to or greater than 1/2 of the repeating pitch PI of the semiconductor device. Accordingly, a channel width can be further expanded, and a large current can be flowed through the channel at the time of the on-operation.

[Tenth Modified Example of Fourth Embodiment]

Next, a tenth modified example of a semiconductor device according to the fourth embodiment will now be explained. The tenth modified example is different from the fourth embodiment shown in Fig. 4A in a point that an impurity concentration in the vicinity of the surface of the first drift region 4 is lowered. In a manufacturing method, when implanting the ions to form the first drift region 4, a dose amount at the time of low energy may be made lower than that at the time of high energy.

Since the impurity concentration of the surface of the first drift region 4 is lower than that of the fourth embodiment mentioned above, there is little electron flow at the surface at the time of conduction, in the operation of the semiconductor device according to the tenth modified example. Therefore, even if process damage occurs on the first main surface of the substrate 1 in the manufacturing process, the influence can be reduced. Moreover, since the depletion layer on the surface of the first drift region 4 is wide in the OFF operation, reduction of a width of the depletion layer due to the process damage can be improved, and a highly reliable semiconductor device can be provided.

[Explanation of Fifth Embodiment]

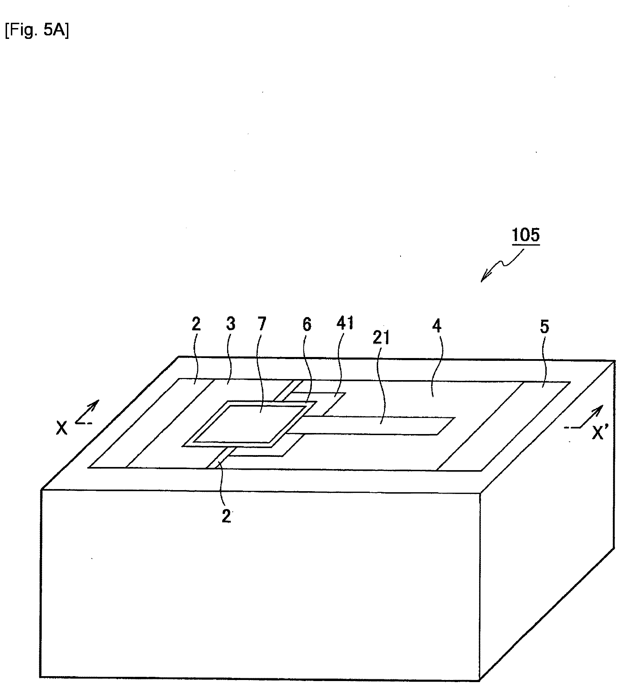

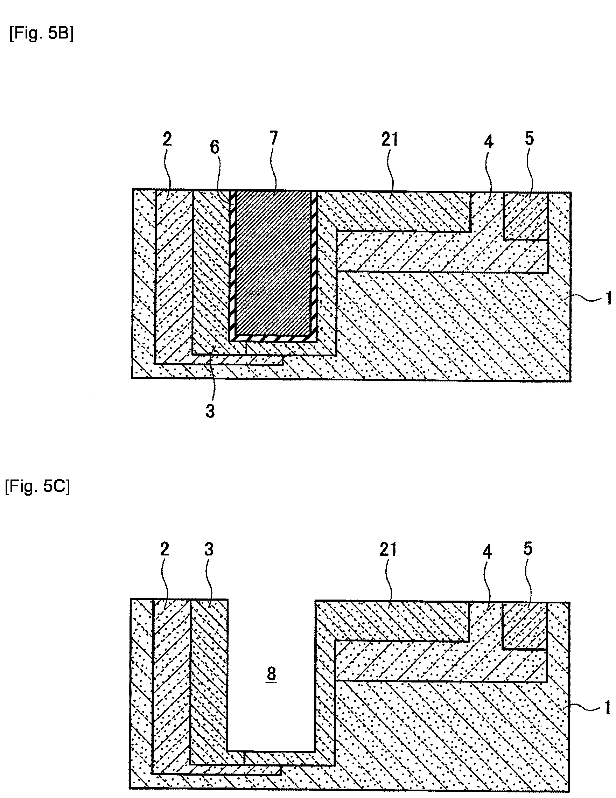

Next, a fifth embodiment of the present invention will now be explained. Fig. 5A is a perspective diagram showing a configuration of a semiconductor device according to the fifth embodiment, and Fig. 5B is a cross-sectional diagram taken in the line X-X' of Fig. 5A. In Figs. 5A and 5B, in order to avoid complicatedness, the description of the interlayer insulating film and the contact hole is omitted.

As shown in Figs. 5A and 5B, the semiconductor device 105 according to the fifth embodiment includes; an insulating semiconductor substrate (substrate 1); and an N-type first drift region 4, an N-type second drift region 41, and a P-type well region 2 which are formed on a first main surface of the substrate 1. The first drift region 4 and the second drift region 41 are contacted with each other, and the second drift region 41 is formed to be deeper than the first drift region 4. The well region 2 is in contact with the second drift region 41.

The semiconductor device 105 includes an N+-type source region 3 formed to extend from a surface of the well region 2 in a direction perpendicular thereto to the inside of the well region 2. The semiconductor device 105 includes an N-type drain region 5 formed to extend from a surface of the first drift region 4 to the inside of the first drift region 4 and to be separated from the well region 2.

A gate trench 8 deeper than the first drift region 4 is formed in a part of the second drift region 41, a part of the well region 2, and a part of the source region 3. The gate trench 8 is in contact with the second drift region 41, the well region 2, and the source region 3.

A gate insulating film 6 is formed on an inner surface of the gate trench 8, and the gate electrode 7 is further formed in the inside thereof. The gate electrode 7 is in contact with the second drift region 41, the well region 2, and the source region 3, via the gate insulating film 6.

A P-type column region 21 is formed on a part of a surface of the first drift region 4 and a part of a surface of the second drift region 41. The column region 21 is in contact with a side surface of the gate trench 8, and also is formed to extend downward in a direction perpendicular thereto, and is formed to a bottom of the gate trench 8. The column region 21 is in contact with the well region 2 at the bottom of the gate trench 8. The column region 21 formed in the first drift region 4 is shallower than the first drift region 4. In other words, a part of the column region 21 is formed to a position shallower than the first drift region 4 inside the first drift region 4, and another part thereof is formed to the bottom of the gate trench 8. The column region 21 has the same electric potential as the source electrode. The column region 21 is formed to be in contact with a part of a surface (side surface on the right hand side in the drawings) of the gate insulating film 6 formed in the gate trench 8 opposite to the drain region 5.

Since the well region 2 is in contact with the side surface of the gate trench 8, an area where the gate trench 8 and the well region 2 are in contact with each other is increased as the gate trench 8 becomes deeper. A source electrode (not illustrated) is provided in contact with the surfaces of the source region 3 and the well region 2. Accordingly, the source region 3 has the same electric potential as the well region 2. Moreover, a drain electrode (not illustrated) is provided in contact with the surface of the drain region 5.

Furthermore, in the fifth embodiment, silicon carbide (SiC) is used as an insulating semiconductor substrate (substrate 1). The insulating substrate shown herein corresponds to a substrate of which a resistivity is several kΩ/cm or more. Here, silicon carbide has several polytypes (polymorphism). The present embodiment is illustrated with an example of using silicon carbide of a common 4H polytype.

[Manufacturing Method of Fifth Embodiment]

Next, the manufacturing method of the semiconductor device 105 according to the fifth embodiment will now be explained. First, the gate trench 8 is formed on the non-doped silicon carbide insulated semiconductor substrate (substrate 1). Next, in order to form the gate trench 8, a mask material (not illustrated) is deposited on the first main surface of the substrate 1 and then is patterned. A silicon oxidation film can be used as the mask material, and as a deposition method, a thermal CVD method and a plasma CVD method can be used. As a patterning method, a general photolithography method can be used. The mask material is etched by using the patterned resist as a mask.

As an etching method, wet etching using hydrofluoric acid and dry etching such as reactive ion etching can be used. Then, using the mask material as the mask, the gate trench 8 is formed by dry etching. The mask is removed after forming the gate trench 8. For example, when the mask material is a silicon oxide film, the mask material 9 is removed by hydrofluoric acid cleaning. Consequently, a cross-sectional structure similar to Fig. 4C mentioned above is obtained.

Next, the first drift region 4 and the second drift region 41 are formed. The first drift region 4 and the second drift region 41 can simultaneously be formed by obliquely ion implantation of N-type impurities. An implantation concentration thereof is preferable to be within a range from $1 \times 10^{14}$ to $1 \times 10^{18}$/cm$^3$. Implantation energy can be set in accordance with depths of the first drift region 4 and the second drift region 41.

An implantation angle is set as an angle such that a bottom of the gate trench 8 is completely surrounded by the N-type region. For example, in the case where the depth of the first drift region 4 is 1 micrometer, implanting of the N-type impurities on the order of MeV is required. If the width of the gate trench 8 is 1 micrometer and the depth is also 1 micrometer, it is preferable to set the implantation angle to equal to or less than 45 degrees. Consequently, a cross-sectional structure similar to Fig. 4D mentioned above can be obtained.

Then, the P-type well region 2, the N+-type source region 3, the drain region 5, and the column region 21 are formed by means of ion implantation on the substrate 1. Although the order to form them is not in particular to be limited, it is preferable to form the well region 2 in advance. Although the source region 3 and the drain region 5 may be simultaneously formed, both are individually formed in the present embodiment.

As a method for patterning an ion-implanted region, a mask material is deposited on the first drift region 4 and the second drift region 41. A silicon oxidation film can be used as the mask material, and as a deposition method, a thermal CVD method and a plasma CVD method can be used. Next, a resist is patterned on the mask material.

As a patterning method, a general photolithography method can be used. The mask material is etched by using the patterned resist as a mask. As an etching method, wet etching using hydrofluoric acid and dry etching such as reactive ion etching can be used.

The resist is then removed by use of oxygen plasma or sulfuric acid. The mask material is used as the mask, P-type impurities and N-type impurities are ion-implanted, to form the P-type well region 2, the N+-type source region 3, the N+-type drain region 5, and the P-type column region 21.

As the P-type impurities, aluminum or boron can be used. As the N-type impurities, nitrogen can be used. At this time, such ions are implanted in a state where the substrate is heated up to approximately 600°C, whereby a crystal defect can be suppressed from occurring in the implanted region. After the ion injection is carried out, the mask material is removed by, for example, etching using hydrofluoric acid.

Fig. 5C shows a cross-sectional structure after forming the well region 2, the source region 3, the drain region, and the column region 21. An impurity concentration of the source region 3 and the drain region 5 formed by the above-mentioned method is preferable to be within a range from $1 \times 10^{18}$/cm$^3$ to $1 \times 10^{21}$/cm$^3$. Moreover, an impurity concentration of the column region 21 and the well region 2 is preferable to be within a range of $1 \times 10^{15}$/cm$^3$ to $1 \times 10^{19}$/cm$^3$. Moreover, each depth of the well region 2, the source region 3, and the P-type column region 21 is made deeper than the bottom surface of the gate trench 8. Subsequently, the impurities thus ion-implanted are activated by performing heat treatment therefor. A heat treatment temperature is preferable to be approximately 1700°C. Moreover, it is preferable to use argon or nitrogen as an atmosphere.

The gate insulating film 6 is formed on the inner surface of the gate trench 8. As a method of forming the gate insulating film 6, a thermal oxidation method or a deposition method can be used. As an example of the thermal oxidation method, the substrate 1 is disposed under an oxygen atmosphere and is heated to approximately 1100°C. A silicon oxide film can be formed at all the portions where the substrate 1 is contacted with oxygen. The gate insulating film 6 thus formed may be subjected to annealing at approximately 1000°C under an atmosphere of nitrogen, argon or N$_2$O in order to decrease an interfacial level at the interface between the well region 2 and the gate insulating film 6.

Moreover, it is also possible as another example of the thermal oxidation method to thermally oxidize directly under an atmosphere of nitrogen monoxide (NO) or dinitrogen monoxide (N$_2$O). The temperature in that case is preferable to be within a range from 1100°C to 1400°C. The thickness of the gate insulating film 6 to be formed is preferable to be several tens of nanometers.

Next, the gate electrode 7 is formed on the inner surface of the gate insulating film 6. Since it is general to use polysilicon as a material of the gate electrode 7, the present embodiment explains an example of depositing the polysilicon. A low pressure CVD method can be used as the deposition method of polysilicon. A thickness of the polysilicon to be deposited is set to be larger than the half of the width of the gate trench 8.

Then, the inside of the gate trench 8 is completely filled up with the polysilicon. For example, when the width of the gate trench 8 is 2 micrometers, the deposition thickness of the polysilicon is thicker than 1 micrometer. The deposited polysilicon is then subjected to annealing in POC$_{13}$ at approximately 950°C so as to form N-type polysilicon and provide the gate electrode 7 with electric conductivity.

Subsequently, the polysilicon of the gate electrode 7 is subjected to etching. The etching performed may be either isotropic etching or anisotropic etching. The etching amount is set such that the polysilicon remains in the gate trench 8. For example, when the width of the gate trench 8 is 2 micrometers, and the polysilicon is deposited with the thickness of 1.5 micrometers, the etching amount is preferably 1.5 micrometers. In addition, several percent of overetching with respect to the polysilicon with the thickness of 1.5 micrometers is a permissible level for the etching.

Then, the interlayer insulating film (not illustrated) is formed. As the interlayer insulating film, it is generally preferable to use the silicon oxide film. As a deposition method, a thermal CVD method or a plasma CVD method can be used. The thickness thereof is preferable to be equal to or greater than 1 micrometer.

After depositing the interlayer insulating film, the contact holes (not illustrated) are formed. A resist (not illustrated) is patterned on the interlayer insulating film 10. As a patterning method, a general photolithography method can be used. The interlayer insulating film is etched by using patterned resist as a mask. As an etching method, wet etching using hydrofluoric acid and dry etching such as reactive ion etching can be used.

Subsequently, the resist is removed by use of oxygen plasma or sulfuric acid. The contact hole used for the source electrode (not illustrated) is formed so that the well region 2 and the source region 3 are simultaneously exposed therefrom.

After forming the contact holes, the source electrode (not illustrated) and the drain electrode (not illustrated) are formed therein. As an electrode material, a metal is generally used. Ti, Ni, Mo, or the like can be used as such a metal. Alternatively, a laminated metal, e.g. Ti / Ni / Ag, may be used therefor. An example of using titanium (Ti) will now be explained in the present embodiment. First, a deposition method, e.g. a sputtering method, is used to deposit titanium (Ti). Subsequently, selective etching by means of a resist mask is subjected to the deposited titanium. Consequently, the semiconductor device 105 according to the fifth embodiment shown in Fig. 5A is completed.

[Explanation of Operation of Fifth Embodiment]

Next, an operation of the semiconductor device 105 according to the fifth embodiment will now be explained. The semiconductor device 105 shown in Fig. 5A controls a voltage of the gate electrode 7 in a state where a positive voltage is applied to the drain electrode 16 while taking a voltage of the source electrode 15 as a reference, and thereby functions as a transistor.

In other words, when a voltage between the gate electrode 7 and the source electrode 15 reaches equal to or greater than a predetermined threshold, an inversion layer is formed in a channel of the well region 2 at the side surface of the gate electrode 7 so as to be turned ON. Then, the current thus flows from the drain electrode 16 to the source electrode 15.

More specifically, electrons flow from the source electrode 15 to the source region 3 and further flow into the second drift region 41 via the channel. Furthermore, the electrons flow into the first drift region 4, and further flow from the first drift region 4 to the drain electrode through the drain region 5. In other words, the current flows from the drain electrode into the source electrode.

Meanwhile, when the voltage between the gate electrode 7 and the source electrode 15 is set at the predetermined threshold voltage or less, the inversion layer disappears, and it is turned to an OFF state, and the current is interrupted. At this time, a high voltage of several hundreds to several thousands of volts is applied between the drain and the source.

At this time, a depletion layer is extended from a PN junction portion between the first drift region 4 and the column region 21, in the semiconductor device 105 of the present embodiment. If a predetermined voltage is applied to the drain electrode 16, the first drift region 4 and the column region 21 are completely depleted.

The electric field intensity in the depletion layer is ideally uniform. If the electric field intensity reaches criticality, an avalanche breakdown occurs and a voltage at this time becomes the breakdown voltage. Thus, the semiconductor device 105 of the present embodiment has the super junction (SJ) structure where the first drift region 4 and the column region 21 are alternately formed. Accordingly, by extending the depletion layer from the both sides of the column region 21, the vertical electric field intensity can be made uniform and the high voltage resistance can be obtained.

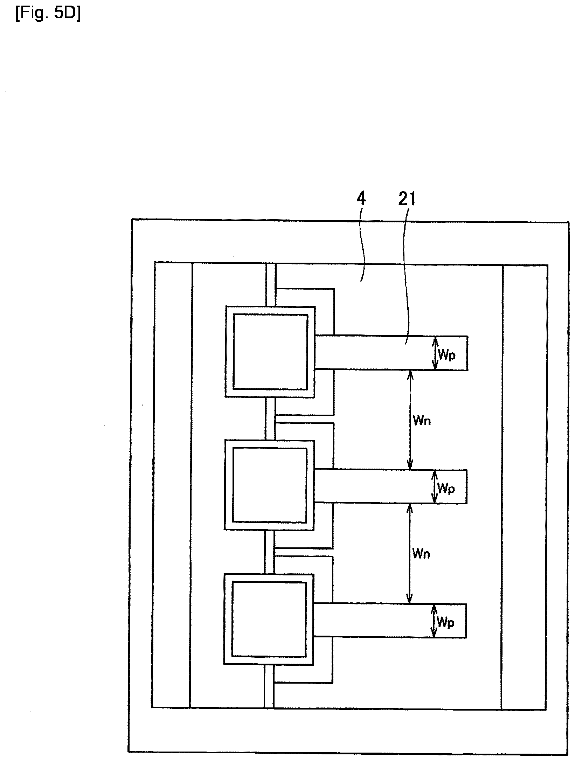

In the present embodiment, Nd denotes a donor concentration of the first drift region 4, Na denotes an acceptor concentration of the column region 21, Wn denotes an interval between the column regions 21, and Wp denotes a width of the column region 21. As shown in Fig. 5D, Wp indicates the width of the column 21 and Wn indicates the interval between the column 21 at the time when a plurality of semiconductor devices are provided side by side.

Moreover, in order to completely deplete the first drift region 4 and the column region 21, it is generally necessary to satisfy the following equation (1):

$$Na \times Wp = Nd \times Wn \qquad ... (1)$$

The donor concentration Nd affects the on-resistance of the semiconductor device, and the on-resistance is decreased as Nd is increased. In order to reduce the on-resistance while maintaining the equation (1), it is necessary to increase Nd and to reduce Wn. For example, when the concentration of the each of the first drift region 4 and the column region 21 is $2 \times 10^{17}/cm^3$, the thickness of the first drift region 4 is 4 micrometers, and the interval between the column region 21 and the width of the column region 21 are 1 micrometer, the resistance of the first drift region 4 is several tens of $\mu\Omega \cdot cm^2$ if the breakdown voltage is 700V.

In other words, when the predetermined voltage is applied to the drain electrode 16, the column region 21 and the first drift region 4 are completely depleted.

Accordingly, the low on-resistance can be realized in the semiconductor device 105 according to the present embodiment.

Moreover, since the column region 21 is formed to be in contact with the side surface of the gate trench 8 (side surface of the right hand side in the drawing) opposite to the drain region 5, it can reduce the pitch of the semiconductor device. Accordingly, the area efficiency of the substrate 1 can be improved, and even if it is a small-sized chip, a large current can be flowed, and the chip costs can be reduced.

Moreover, since the column region 21 which is present in the first drift region 4 is formed shallower than the first drift region 4, it can reduce the energy when forming the column region 21 by means of the ion implantation. Consequently, the costs of the ion implantation can be reduced.

Furthermore, in the present embodiment, the column region 21 and the well region 2 are in contact with the bottom of the gate trench 8, and both have the same electric potential. Accordingly, since there is no necessary to form a connection section to connect with wiring in the column region 21 and the well region 2 as conventional, area efficiency can be improved.

Moreover, the present embodiment is configured so that the deeper the gate trench 8 is, the larger the area in which the gate trench 8 and the well region 2 are in contact with each other. Accordingly, since the deeper the gate trench 8 is, the wider the channel width is, and the wider the path through which the current flows is, a resistance of current which flows into the channel can be reduced. Moreover, since the second drift region 41 is formed so as to be deeper than the first drift region 4, the current path in the channel can be widened, and thereby the resistance can be reduced.

Furthermore, in the present embodiment, silicon carbide (SiC) is used as the material of the substrate 1. Since silicon carbide has high insulating performance are high thermal conductivity, it can efficiently be cooled by attaching a cooler (not illustrated) on a back side surface of the substrate 1 via a conductive material. In other words, a heat generated due to a current which flows when the semiconductor device 105 is turned ON can efficiently radiate. Moreover, since silicon carbide is a semiconductor having a wide bandgap and has few intrinsic carriers, the semiconductor device effectively exerting high insulating performance. Accordingly, the semiconductor device having high voltage resistance can be provided.

As mentioned above, although the semiconductor device of the present invention and the manufacturing method thereof have been explained on the basis of the illustrated embodiments, the present invention is not limited thereto, and the configuration of each part can be replaced by any configurations having a similar function.

For example, although each above-mentioned embodiment has explained the example of using the silicon carbide substrate as the substrate 1, the present invention can use not only the silicon carbide substrate but also substrates having wide bandgap semiconducting materials, e.g. GaN, diamond, ZnO, or AlGaN.

Although each above-mentioned embodiment has explained the example of using the N-type polysilicon as the gate electrode, P-type polysilicon may be used instead. Alternatively, conducting materials, e.g. P-type polysilicon carbide, SiGe, or Al, may be used.

Moreover, although each above-mentioned embodiment has explained the example of using the silicon oxide film as the gate insulating film, a silicon nitride film can also be used. Alternatively, a layer in which a silicon oxide film and a silicon nitride film are laminated may be used.

REFERENCE SIGNS LIST

| | |
|---|---|
| 1 | Substrate |
| 2 | Well region |
| 3 | Source region |
| 4 | First drift region |
| 5 | Drain region |
| 6 | Gate insulating film |
| 7 | Gate electrode |
| 8 | Gate trench |
| 9 | Mask material |
| 10 | Interlayer insulating film |
| 11a | Contact hole |
| 11b | Contact hole |
| 15 | Source electrode |
| 16 | Drain electrode |
| 17 | Source trench |
| 21 | Column region |
| 41 | Second drift region |
| 101 | Semiconductor device |
| 102 | Semiconductor device |
| 102a | Semiconductor device |
| 102b | Semiconductor device |
| 103 | Semiconductor device |
| 104 | Semiconductor device |
| 104a | Semiconductor device |
| 104b | Semiconductor device |
| 104c | Semiconductor device |
| 104d | Semiconductor device |
| 104e | Semiconductor device |
| 104f | Semiconductor device |
| 104g | Semiconductor device |
| 105 | Semiconductor device |

**Claims**

1. A semiconductor device comprising:

   a substrate,
   a first conductivity-type first drift region formed on a first main surface of the substrate;

a first conductivity-type second drift region formed on the first main surface of the substrate so as to be contacted with the first drift region, the second drift region formed to be reached to a deeper position of the substrate than a position of the first drift region;

a second conductivity-type well region formed on the first main surface of the substrate, the well region in contact with the second drift region;

a first conductivity-type source region formed in the well region to extend in a direction perpendicular to a surface of the well region;

a first conductivity type drain region formed in the first drift region to be separated from the well region, the drain region extend from a surface of the first drift region in a perpendicular direction;

a gate insulating film formed so as to be in contact with the second drift region, the well region and the source region;

a gate electrode formed so as to be in contact with the gate insulating film, the gate electrode further in contact with the second drift region, the well region, and the source region, via the gate insulating film;

a source electrode connected to the source region and the well region; and

a drain electrode connected to the drain region.

2. The semiconductor device according to claim 1, wherein
an impurity concentration of the second drift region is lower than an impurity concentration of the first drift region.

3. The semiconductor device according to claim 1 or 2, wherein
the substrate is a semi-insulating substrate or an insulating substrate.

4. The semiconductor device according to any one of claims 1 to 3, wherein
the substrate is a wideband gap semiconductor.

5. The semiconductor device according to any one of claims 1 to 4, further comprising
a gate trench formed so as to be in contact with the second drift region, wherein the gate insulating film and the gate electrode are formed on an inner surface of the gate trench.

6. The semiconductor device according to claim 5, wherein
the deeper the gate trench is, the larger an area in which the gate insulating film and the well region are in contact with each other.

7. The semiconductor device according to claim 5 or 6, wherein
the gate trench is formed so as to be deeper than the second drift region.

8. The semiconductor device according to any one of claims 5 to 7, wherein
the well region is deeper than the gate trench.

9. The semiconductor device according to any one of claims 1 to 8, wherein
when the gate electrode, the source electrode, and the drain electrode have the same voltage, the second drift region is completely depleted.

10. The semiconductor device according to any one of claims 1 to 9, wherein
an impurity concentration in a vicinity of the surface of the first drift region is low.

11. The semiconductor device according to any one of claims 5 to 8, further comprising
a second conductivity-type column region of which a part is formed to a position shallower than the first drift region in the first drift region, and another part is formed to a bottom of the gate trench, in contact with the source region, wherein
the column region has the same electric potential as the source electrode.

12. The semiconductor device according to claim 11, wherein
the column region is in contact with at least a part of a surface of the gate insulating film opposite to the drain electrode.

13. The semiconductor device according to claim 11 or 12, wherein
when a predetermined voltage is applied to the drain electrode, the column region and the first drift region are completely depleted.

14. A manufacturing method of a semiconductor device, the semiconductor device comprising:

a substrate;

a first conductivity-type first drift region formed on a first main surface of the substrate;

a first conductivity-type second drift region formed on the first main surface of the substrate so as to be contacted with the first drift region, the second drift region formed to be reached to a deeper position of the substrate than a position of the first drift region;

a second conductivity-type well region formed on the first main surface of the substrate, the well region in contact with the second drift region;

a first conductivity-type source region formed in the well region to extend in a direction perpendicular to a surface of the well region;

a first conductivity type drain region formed in the first drift region to be separated from the well region, the drain region extend from a surface of the first drift region in a perpendicular direction;

a gate insulating film formed so as to be in contact with the second drift region, the well region and the source region;

a gate electrode formed so as to be in contact with the gate insulating film, the gate electrode further in contact with the second drift region, the well region, and the source region, via the gate insulating film;

a source electrode connected to the source region and the well region; and

a drain electrode connected to the drain region, wherein

the first drift region and the second drift region are formed by implanting impurities to be activated.

15. The manufacturing method of the semiconductor device according to claim 14, wherein
the implanting of the impurities is performed by means of ion implantation method.

16. The manufacturing method of the semiconductor device according to claim 14 or 15, wherein
the first drift region and the second drift region are simultaneously formed.

17. A manufacturing method of a semiconductor device, the semiconductor device comprising:

substrate;

a first conductivity-type first drift region formed on a first main surface of the substrate;

a first conductivity-type second drift region formed on the first main surface of the substrate so as to be contacted with the first drift region, the second drift region formed to be reached to a deeper position of the substrate than a position of the first drift region;

a second conductivity-type well region formed on the first main surface of the substrate, the well region in contact with the second drift region;

a first conductivity-type source region formed in the well region to extend in a direction perpendicular to a surface of the well region;

a first conductivity type drain region formed in the first drift region to be separated from the well region, the drain region extend from a surface of the first drift region in a perpendicular direction;

a gate insulating film formed so as to be in contact with the second drift region, the well region and the source region;

a gate electrode formed so as to be in contact with the gate insulating film, the gate electrode further in contact with the second drift region, the well region, and the source region, via the gate insulating film;

a source electrode connected to the source region and the well region;

a drain electrode connected to the drain region; and

a gate trench formed in the second drift region, wherein

after forming the gate trench, the second drift region is formed.

[Fig. 1A]

[Fig. 1B]

[Fig. 1C]

[Fig. 1D]

[Fig. 1E]

[Fig. 1F]

[Fig. 1G]

[Fig. 1H]

[Fig. 1I]

[Fig. 2A]

[Fig. 2B]

[Fig. 2C]

[Fig. 2D]

[Fig. 2E]

[Fig. 2F]

[Fig. 2G]

[Fig. 2H]

[Fig. 2I]

[Fig. 3A]

[Fig. 3B]

[Fig. 3C]

[Fig. 3D]

[Fig. 4A]

[Fig. 4B]

[Fig. 4C]

EP 3 584 824 A1

[Fig. 4D]

4　　41　　4

<u>8</u>

1

[Fig. 4E]

2　3　41　4

4

<u>8</u>

5

1

39

[Fig. 4F]

[Fig. 4G]

[Fig. 4H]

[Fig. 4I]

[Fig. 4J]

[Fig. 4K]

[Fig. 4L]

[Fig. 4M]

104g

15 3 7 6 41 4 16

P1

5

2

1

[Fig. 5A]

[Fig. 5B]

[Fig. 5C]

[Fig. 5D]

**EP 3 584 824 A1**

## INTERNATIONAL SEARCH REPORT

| International application No. |
| --- |
| PCT/JP2017/005333 |

**A. CLASSIFICATION OF SUBJECT MATTER**
*H01L21/336*(2006.01)i, *H01L29/12*(2006.01)i, *H01L29/78*(2006.01)i

According to International Patent Classification (IPC) or to both national classification and IPC

**B. FIELDS SEARCHED**

Minimum documentation searched (classification system followed by classification symbols)
H01L21/336, H01L29/12, H01L29/78

Documentation searched other than minimum documentation to the extent that such documents are included in the fields searched
| Jitsuyo Shinan Koho | 1922–1996 | Jitsuyo Shinan Toroku Koho | 1996–2017 |
| Kokai Jitsuyo Shinan Koho | 1971–2017 | Toroku Jitsuyo Shinan Koho | 1994–2017 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y<br>A | JP 2004-031804 A (Sanyo Electric Co., Ltd.),<br>09 December 2004 (09.12.2004),<br>paragraphs [0001] to [0030]; fig. 1 to 5<br>& US 2004/0053471 A1<br>paragraphs [0001] to [0072]; fig. 1 to 5<br>& TW 200400638 A          & KR 10-2004-0002735 A<br>& CN 1479382 A | 1-8,10,14,15<br>9,11-13,16,<br>17 |
| Y | JP 11-103058 A (Toshiba Corp.),<br>13 April 1999 (13.04.1999),<br>fig. 10<br>& US 6452231 B1<br>fig. 12 | 1-8,10,14,15 |

☒ Further documents are listed in the continuation of Box C.   ☐ See patent family annex.

| | |
| --- | --- |
| * Special categories of cited documents:<br>"A" document defining the general state of the art which is not considered   to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>28 April 2017 (28.04.17) | Date of mailing of the international search report<br>16 May 2017 (16.05.17) |
| --- | --- |
| Name and mailing address of the ISA/<br>Japan Patent Office<br>3-4-3,Kasumigaseki,Chiyoda-ku,<br>Tokyo 100-8915,Japan | Authorized officer<br><br>Telephone No. |

Form PCT/ISA/210 (second sheet) (January 2015)

**INTERNATIONAL SEARCH REPORT**

International application No.

PCT/JP2017/005333

| C (Continuation). | DOCUMENTS CONSIDERED TO BE RELEVANT | |
| --- | --- | --- |
| Category* | Citation of document, with indication, where appropriate, of the relevant passages | Relevant to claim No. |
| Y | WO 2015/008550 A1 (Nissan Motor Co., Ltd.), 22 January 2015 (22.01.2015), paragraph [0012]; fig. 1 & US 2016/0181371 A1 paragraph [0042]; fig. 1 & EP 3024018 A1 & CN 105556647 A | 1-8,10,14,15 |
| A | US 2004/0065919 A1 (Wilson, H. Peter et al.), 08 April 2004 (08.04.2004), entire text; all drawings (Family: none) | 1-17 |
| A | US 2013/0256794 A1 (Samsung Electronics Co., Ltd.), 03 October 2013 (03.10.2013), entire text; all drawings & KR 10-2013-0110483 A | 1-17 |
| A | JP 2009-267211 A (Panasonic Corp.), 12 November 2009 (12.11.2009), entire text; all drawings & US 2009/0267144 A1 | 1-17 |
| A | JP 2004-111614 A (Nissan Motor Co., Ltd.), 08 April 2004 (08.04.2004), entire text; all drawings (Family: none) | 1-17 |
| A | JP 2008-210994 A (NEC Electronics Corp.), 11 September 2008 (11.09.2008), entire text; all drawings & US 2008/0203472 A1 | 1-17 |
| A | JP 04-018762 A (Hitachi, Ltd.), 22 January 1992 (22.01.1992), entire text; all drawings (Family: none) | 1-17 |
| A | JP 2013-135233 A (Samsung Electronics Co., Ltd.), 08 July 2013 (08.07.2013), entire text; all drawings & US 2013/0146974 A1 & KR 10-2013-0072794 A & CN 103177967 A & TW 201330115 A | 1-17 |
| A | JP 2004-214611 A (Denso Corp.), 29 July 2004 (29.07.2004), entire text; all drawings & US 2004/0119091 A1 & DE 10358697 A1 | 1-17 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2015008550 A
- JP 2006303543 A

- WO 1998059374 A